# EUROPEAN PATENT APPLICATION

(11) **EP 4 770 361 A1**
(43) Date of publication of application: **01.07.2026**
(21) Application number: 24896663.2
(22) Date of filing: 28.11.2024
(51) Int. Cl.: H10K 39/12

(54) **SOLAR CELL MODULE AND PREPARATION METHOD THEREFOR, PHOTOVOLTAIC DEVICE, ELECTRIC APPARATUS, AND POWER GENERATION APPARATUS**

(30) Priority: 30.11.2023 CN 202311629281
(71) Applicant: Contemporary Amperex Future Energy Research Institute (Shanghai) Limited, Shanghai 200241 (CN); Contemporary Amperex Technology Co., Limited, Ningde, Fujian 352100 (CN)
(72) Inventor: CHEN, Chen, Shanghai 200241 (CN); LI, Yaru, Shanghai 200241 (CN); GU, Shuai, Shanghai 200241 (CN); CHEN, Junchao, Shanghai 200241 (CN); MENG, Ke, Shanghai 200241 (CN); GUO, Yongsheng, Shanghai 200241 (CN); CHEN, Guodong, Shanghai 200241 (CN)
(74) Representative: Gong, Jinping
(86) International application number: PCT/CN2024/135340
(87) International publication number: WO 2025/113578

(57) **Abstract**

This application relates to a solar cell module and a method for preparing the same, a photovoltaic device, an electrical device, and a power generation device. In two adjacent sub-cells, a conductor is connected to a conductive layer of one sub-cell, with at least a portion protruding beyond at least one end of the conductive layer along a second direction. The electrode layer of the other sub-cell can connect with the protruding portion of the conductor outside the sub-cell, achieving series connection between the two sub-cells outside the sub-cells. This eliminates the need for the conventional two scribing operations before electrode layer deposition to achieve series connection, requiring only a cutting operation between sub-cells. Such a design, by providing a conductor protruding at least one end of the conductive layer along the second direction, eliminates the two scribing operations before sub-cell series connection, facilitating a single-cut preparation method, simplifying the preparation process, and improving preparation efficiency. Additionally, eliminating the two scribing operations reduces the likelihood of increased series resistance between sub-cells, thereby enhancing module performance.

## Description

### RELATED APPLICATIONS

This application claims priority to the Chinese patent application filed on November 30, 2023, with application number 2023116292812, and entitled "SOLAR CELL MODULE AND METHOD FOR PREPARING SAME, PHOTOVOLTAIC DEVICE, ELECTRICAL DEVICE, AND POWER GENERATION DEVICE", which is incorporated herein by reference in its entirety.

### TECHNICAL FIELD

This application relates to the technical field of solar cells, and in particular, to a solar cell module and a method for preparing the same, a photovoltaic device, an electrical device, and a power generation device.

### BACKGROUND ART

A solar cell module is a device that converts light energy into electrical energy using the photovoltaic effect. During the preparation process, scribing is typically employed to achieve series connection of sub-cells within the module. For example: P1 scribing cuts through the conductive layer; P2 scribing cuts through the semiconductor layer and both upper and lower transport layers, while allowing the metal electrode layer to contact the conductive layer; and P3 scribing separates adjacent sub-cells.

However, due to limitations in the structural design of conventional solar cell modules, their preparation methods are complex. This complexity can lead to structural damage during scribing of the solar cell module, resulting in reduced performance of the solar cell module.

### SUMMARY OF THE INVENTION

In view of this, it is necessary to provide a solar cell module and a method for preparing the same, a photovoltaic device, an electrical device, and a power generation device, which simplify the preparation process. Additionally, during preparation, the likelihood of damaging the structure of the solar cell module is reduced, thereby enhancing module performance.

According to a first aspect, this application provides a solar cell module, including: at least two sub-cells distributed at intervals along a first direction, each sub-cell including a conductive layer, a functional layer group, and an electrode layer stacked together; where the solar cell module further includes a conductor, and in two adjacent sub-cells, the conductor is connected to the conductive layer of one sub-cell and at least a portion of the conductor protrudes beyond at least one end of the current conductive layer along a second direction, the portion of the conductor protruding beyond the conductive layer is connected to the electrode layer of the other sub-cell, the first direction intersects the second direction, and a plane formed by the two intersects a thickness direction of the solar cell module.

In the above solar cell module, in two adjacent sub-cells, the conductor is connected to the conductive layer of one sub-cell, with at least a portion of the conductor protruding beyond at least one end of the conductive layer along the second direction. That is, at least part of the conductor is located outside the sub-cell, allowing the electrode layer of the other sub-cell to connect with the protruding portion of the conductor outside the sub-cell, thereby achieving a series connection between the two sub-cells outside the sub-cell. This eliminates the need for the conventional two scribing operations before electrode layer deposition to achieve series connection, requiring only a cutting operation between sub-cells. Such a design, by providing a conductor protruding at least one end of the conductive layer along the second direction, eliminates the two scribing operations before sub-cell series connection, facilitating a single-cut preparation method, simplifying the preparation process, and improving preparation efficiency. Additionally, eliminating the two scribing operations before series connection reduces the likelihood of cutting damage to the conductive layer, effectively lowering the chance of increased series resistance between sub-cells, thereby enhancing module performance.

In some embodiments, the conductor is disposed on a side of the conductive layer facing the functional layer group and extends beyond at least one end of the conductive layer along the second direction. In this design, the conductor is placed on one side of the conductive layer, facilitating rapid current conduction along the second direction on the conductive layer through the conductor, which helps reduce resistance during current conduction and improves module performance.

In some embodiments, two ends of the conductor in a sub-cell respectively protrude beyond two opposite ends of the conductive layer along the second direction, with at least one of the two ends of the conductor connected to the electrode layer of an adjacent sub-cell. For example, designing both two ends of the conductor to extend beyond the conductive layer facilitates connection between the electrode layer of the adjacent sub-cell and the conductive layer of the current sub-cell through the protruding portion of the conductor, thereby achieving series connection between sub-cells.

In some embodiments, among the two ends of the conductor in a sub-cell, one protrudes beyond one end of the conductive layer along the second direction. This design allows the electrode layer of an adjacent sub-cell to connect with the conductive layer of the current sub-cell through one end of the conductor, achieving series connection between sub-cells.

In some embodiments, the conductor includes a first component and a second component, the first component and the second component being discontinuously distributed, the first component and the second component respectively protruding beyond the opposite ends of the conductive layer of the respective sub-cell along the second direction and both being connected to the electrode layer of an adjacent sub-cell. This design facilitates series connection between two adjacent sub-cells through the disconnected first component and second component.

In some embodiments, a scribe groove is provided between two adjacent sub-cells, and the conductor is located on at least one side of the scribe groove along the first direction and is disposed on the conductive layer. In this design, the conductor is placed on one side of the scribe groove, facilitating connection between the electrode layer and the conductor to achieve series connection between sub-cells.

In some embodiments, the solar cell module includes multiple scribe grooves and multiple conductors, with at least one conductor located between two adjacent scribe grooves. In this design, conductors are placed between two adjacent scribe grooves, facilitating sequential connection between electrode layers and conductors to form a series connection.

In some embodiments, a dimension of the conductor along the first direction is smaller than a dimension of the conductive layer along the first direction. This design, by controlling the dimensional relationship between the conductor and the conductive layer, reduces the dead zone range on the conductive layer, thereby improving module performance.

In some embodiments, the dimension of the conductor along the first direction is denoted as W, where 30 µm ≤ W ≤ 200 µm. This design allows the controlling of the dimension of the conductor along the first direction within 30 µm to 200 µm, satisfying rapid current flow while controlling the size of the dead zone range on the conductive layer, thus enhancing the performance of the solar cell module.

In some embodiments, the dimension W further satisfies a condition: 80 µm ≤ W ≤ 100 µm. This design further allows the controlling of the dimension of the conductor along the first direction within 80 µm to 100 µm, enabling the design of the conductor to effectively balance its own conductive performance and the effective region on the conductive layer.

In some embodiments, a dimension of the conductor along the thickness direction is denoted as h, where h > 0 nm. In this design, a conductor is introduced to achieve series connection between two sub-cells, replacing the conventional P1 and P2 scribing, simplifying the preparation process, and effectively reducing the likelihood of damage to the solar cell module, thereby improving module performance.

In some embodiments, the dimension h further satisfies a condition: h ≥ 40 nm. This design allows the controlling of the thickness of the conductor to be 40 nm or more, ensuring good conductive performance.

In some embodiments, the dimension h further satisfies a condition: 40 nm ≤ h ≤ 300 nm. This design allows the controlling of the dimension of the conductor along the thickness direction within 40 nm to 300 nm, ensuring good current-carrying capacity of the solar cell module while maintaining structural stability of the solar cell module.

In some embodiments, the dimension h further satisfies a condition: 50 nm ≤ h ≤ 150 nm. This design allows the controlling of the dimension of the conductor along the thickness direction within 40 nm to 300 nm, ensuring good current-carrying capacity of the solar cell module while maintaining structural stability of the solar cell module. In some embodiments, the dimension h further satisfies a condition: 80 nm ≤ h ≤ 150 nm. This design allows further controlling of the dimension of the conductor along the thickness direction within 80 nm to 150 nm, ensuring good current-carrying capacity while maintaining structural stability of the solar cell module, thereby improving module performance.

In some embodiments, a conductivity of the conductor is greater than or equal to a conductivity of the conductive layer. In this design, the conductivity of the conductor is rationally set to facilitate rapid current transmission through the conductor, thereby improving the conductive performance of the module.

In some embodiments, the conductivity of the conductor is greater or equal to 5×10⁶ S/m. In this design, the conductivity of the conductor is rationally set to facilitate rapid current transmission through the conductor, thereby improving the conductive performance of the module.

In some embodiments, the material of the conductor may be a single metal, such as silver, copper, gold, aluminum, magnesium, tungsten, molybdenum, zinc, cobalt, nickel, potassium, lithium, iron, platinum, or tin; or it may be a non-metal material, such as carbon fiber, zinc oxide, conductive polymer material, conductive polymeric material, or conductive ceramic material.

In some embodiments, the conductive layer includes at least one of indium-doped tin oxide, fluorine-doped tin oxide, aluminum-doped zinc oxide, lanthanide-doped indium oxide, antimony-doped tin oxide, boron-doped zinc oxide, indium zinc oxide, gallium zinc oxide, or indium tungsten oxide. In this design, the material of the conductive layer is rationally selected to ensure good conductive performance of the conductive layer.

In some embodiments, each electrode layer includes a main body portion and a connection portion connected to the main body portion, the main body portion being disposed on a side of the functional layer group facing away from the conductive layer, and the connection portion being located on at least one side of the sub-cell along the second direction; and in two adjacent sub-cells, the connection portion of one sub-cell is connected to the conductor of the other sub-cell. In this design, the electrode layer is configured with a main body portion and a connection portion, using the main body portion to cover the functional layer group to facilitate current collection to the main body portion, while the connection portion enables connection between the electrode layer and the conductor of the next sub-cell along the current direction, achieving stable series connection between sub-cells.

In some embodiments, two opposite ends of the functional layer group along the second direction respectively extend beyond the conductive layer along the second direction. In this design, the functional layer group is used to cover the conductive layer along the second direction, preventing exposure of the conductive layer along the second direction and reducing the risk of short circuits due to direct contact between the electrode layer and the conductive layer.

In some embodiments, the solar cell module further includes a substrate, with the conductive layer disposed on the substrate. In this design, a substrate is introduced to provide support and protection for the functional layer group.

In some embodiments, the functional layer group includes a first transport layer, a perovskite layer, and a second transport layer stacked sequentially, with the first transport layer disposed on the conductive layer and the electrode layer disposed on the second transport layer. In this design, the first transport layer, perovskite layer, and second transport layer are introduced to form a stable perovskite cell module.

In some embodiments, the first transport layer is a hole transport layer, and the second transport layer is an electron transport layer. This design allows the formation of a solar cell module with an inverted structure.

In some embodiments, the first transport layer is an electron transport layer, and the second transport layer is a hole transport layer. This design allows the formation of a solar cell module with a regular structure.

According to a second aspect, this application provides a method for preparing a solar cell module, including the following steps: forming a conductive layer extending along a first direction on a substrate; disposing a conductor on the conductive layer, where at least a portion of the conductor protrudes beyond at least one end of the conductive layer along a second direction, the first direction intersecting the second direction, and a plane formed by the two intersecting a thickness direction of the solar cell module; sequentially forming a functional layer group and an electrode layer on the conductive layer, and connecting the electrode layer to the portion of the conductor protruding beyond the conductive layer; and cutting on the electrode layer at a position on one side of the conductor along the first direction, and cutting to the substrate.

In the above method for preparing a solar cell module, when forming the conductor, at least a portion of the conductor protrudes beyond at least one end of the conductive layer along the second direction. That is, at least part of the conductor is located outside the sub-cell, allowing the electrode layer of another sub-cell to connect with the protruding portion of the conductor outside the sub-cell, thereby achieving series connection between the two sub-cells outside the sub-cells. This eliminates the need for the conventional two scribing operations before electrode layer deposition to achieve series connection, requiring only a cutting operation between sub-cells. Such a design, by forming a conductor at at least one end of the conductive layer along the second direction, eliminates the two scribing operations before sub-cell series connection, facilitating a single-cut preparation method, simplifying the preparation process, and improving preparation efficiency. Additionally, eliminating the two scribing operations before series connection reduces cutting damage to the conductive layer, effectively lowering the chance of increased series resistance between sub-cells, thereby enhancing module performance.

In some embodiments, the step of disposing a conductor on the conductive layer includes: forming the conductor on a side of the conductive layer facing away from the substrate, and controlling at least one end of the conductor to extend beyond the conductive layer along the second direction. This design allows the formation of the conductor on one side of the conductive layer, facilitating rapid current conduction along the second direction on the conductive layer through the conductor, which helps reduce resistance during current conduction and improves module performance.

In some embodiments, in the step of forming the conductor on a side of the conductive layer facing away from the substrate, the conductor is provided in plurality, and at least part of the conductors are distributed at intervals along the first direction on the conductive layer. In this design, multiple conductors are provided, facilitating stable series connection for sub-cells formed by cutting through the conductors.

In some embodiments, the step of sequentially forming a functional layer group and an electrode layer on the conductive layer, and connecting the electrode layer to the portion of the conductor protruding beyond the conductive layer, includes: forming the functional layer group on the conductive layer; and forming a main body portion of the electrode layer on a side of the functional layer group facing away from the conductive layer, and forming the connection portion of the electrode layer at at least one end of the functional layer group along the second direction, where a connection portion is present on each of two sides of the conductor along the first direction, with the conductor connected to one connection portion and not connected to the other connection portion. In this design, the electrode layer is configured with a main body portion and a connection portion, using the main body portion to cover the functional layer group to facilitate current collection to the main body portion, while the connection portion enables connection between the electrode layer and the conductor, achieving stable series connection between sub-cells.

In some embodiments, after the step of forming a conductive layer extending along a first direction on a substrate, the method further includes: etching at least one edge of a surface of the conductive layer along the second direction to the substrate to form an etched region, where the etched region does not contain the conductive layer. In this design, the effective region of the conductive layer is reduced through etching, allowing the functional layer group to cover the conductive layer along the second direction in subsequent synthesis, preventing direct contact between the electrode layer and the conductive layer, thereby reducing the risk of short circuits that may otherwise occur due to direct contact between the electrode layer and the conductive layer during formation of the electrode layer.

In some embodiments, the step of forming a conductive layer extending along a first direction on a substrate includes: covering at least one edge of a surface of the substrate along the second direction with a mask plate; and forming the conductive layer on the substrate with the mask plate. In this design, the effective region of the conductive layer is reduced through the mask plate, allowing the functional layer group to cover the conductive layer along the second direction in subsequent synthesis, preventing direct contact between the electrode layer and the conductive layer, thereby reducing the risk of short circuits that may otherwise occur due to direct contact between the electrode layer and the conductive layer during formation of the electrode layer.

According to a third aspect, this application provides a photovoltaic device, where the photovoltaic device includes the solar cell module according to any one of the above embodiments.

According to a fourth aspect, this application provides an electrical device, where the electrical device includes the solar cell module according to any one of the above embodiments.

According to a fifth aspect, this application provides a power generation device, where the power generation device includes the solar cell module according to any one of the above embodiments.

### DESCRIPTION OF THE DRAWINGS

To more clearly illustrate the technical solutions of the embodiments of this application, the drawings required for use in the embodiments of this application are briefly introduced below. Obviously, the drawings described below are only some embodiments of this application, and those of ordinary skill in the art can obtain other drawings based on these drawings without creative effort.
FIG. 1 is a front view of a structure of a solar cell module according to some embodiments of this application.
FIG. 2 is a top view of a structure of a solar cell module according to some embodiments of this application.
FIG. 3 is a front view of a structure of a solar cell module according to some other embodiments of this application.
FIG. 4 is a schematic diagram of a structure of a conductor on a conductive layer according to some embodiments of this application.
FIG. 5 (a) and (b) are schematic diagrams of structures of different distributions of a conductor on a conductive layer according to some other embodiments of this application.
FIG. 6 is a schematic diagram of a structure of a conductor on a conductive layer according to some further embodiments of this application.
FIG. 7 is an enlarged schematic diagram of a structure at circle A in FIG. 2.
FIG. 8 (a) and (b) are analysis diagrams of current flow in a solar cell module from different perspectives.
FIG. 9 is a first schematic diagram of a preparation process flow of a solar cell module according to some embodiments of this application.
FIG. 10 is a schematic diagram of a structure of forming a conductive layer on a substrate according to some embodiments of this application.
FIG. 11 is a schematic diagram of a structure of forming a functional layer group on a conductive layer according to some embodiments of this application.
FIG. 12 is a schematic diagram of a structure of forming an electrode layer on a functional layer group according to some embodiments of this application.
FIG. 13 is a second schematic diagram of a preparation process flow of a solar cell module according to some embodiments of this application.
FIG. 14 is a third schematic diagram of a preparation process flow of a solar cell module according to some embodiments of this application.
FIG. 15 is a fourth schematic diagram of a preparation process flow of a solar cell module according to some embodiments of this application.

100, solar cell module; 10, substrate; 11, etched region; 20, sub-cell; 21, conductive layer; 22, functional layer group; 221, first transport layer; 222, perovskite layer; 223, second transport layer; 23, electrode layer; 231, main body portion; 232, connection portion; 23a, first portion; 23b, second portion; 233, disconnection gap; 2a, first sub-cell; 2a1, first conductive layer; 2a2, first functional layer group; 2a3, first electrode layer; 2b, second sub-cell; 2b1, second conductive layer; 2b2, second functional layer group; 2b3, second electrode layer; 30, scribe groove; 40, conductor; 41, first component; 42, second component; X, first direction; Y, second direction; and Z, thickness direction.

### DETAILED DESCRIPTION

To make the objectives, features, and advantages of this application more apparent and understandable, the specific embodiments of this application are described in detail below in conjunction with the drawings. In the following description, numerous specific details are set forth to provide a thorough understanding of this application. However, this application can be implemented in many ways other than those described herein, and those skilled in the art can make similar improvements without departing from the gist of this application. Therefore, this application is not limited by the specific embodiments disclosed below.

In the description of this application, it should be understood that terms such as "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", and "circumferential" indicate orientations or positional relationships based on those shown in the drawings. These terms are used solely for convenience in describing this application and simplifying the description, and do not indicate or imply that the referenced device or element must have a specific orientation, be constructed, or operate in a specific orientation. Therefore, they should not be construed as limiting this application.

Furthermore, terms such as "first" and "second" are used for descriptive purposes only and should not be construed as indicating or implying relative importance or implicitly specifying the number of technical features indicated. Thus, a feature defined with "first" or "second" may explicitly or implicitly include at least one such feature. In the description of this application, the term "multiple" means at least two, such as two, three, and the like, unless explicitly and specifically limited otherwise.

In this application, unless otherwise expressly specified and limited, terms such as "mounted", "connected", "coupled", and "fixed" should be understood broadly. For example, they may refer to a fixed connection, a detachable connection, or an integral connection; a mechanical connection or an electrical connection; a direct connection or an indirect connection via an intermediate medium; or an internal communication or interaction between two elements, unless explicitly limited otherwise. Those of ordinary skill in the art can understand the specific meanings of these terms in this application based on the specific context.

In this application, unless otherwise expressly specified and limited, descriptions such as a first feature being "on" or "under" a second feature may mean that the first and second features are in direct contact, or in indirect contact through an intermediate medium. Moreover, a first feature being "above", "over", or "on top of' a second feature may mean that the first feature is directly above or obliquely above the second feature, or merely that the first feature is at a higher horizontal level than the second feature. A first feature being "below", "under", or "beneath" a second feature may mean that the first feature is directly below or obliquely below the second feature, or merely that the first feature is at a lower horizontal level than the second feature.

It should be noted that if an element is referred to as being "fixed to" or "disposed on" another element, it may be directly on the other element or there may be an intervening element. If an element is referred to as being "connected" to another element, it may be directly connected to the other element or there may also be an intervening element. The terms "vertical", "horizontal", "upper", "lower", "left", "right", and similar expressions used in this application are for illustrative purposes only and do not indicate a unique implementation.

With the advancement of science, breakthroughs in the development of new energy sources continue to emerge. For example, solar cells represented by perovskite and organic thinfilm cells have achieved revolutionary progress, and due to their advantages of high efficiency and low cost, they are expected to replace silicon-based solar cells.

For solar cell modules, to achieve suitable voltage and current output, laser or mechanical scribing is often used to divide and connect sub-cells in series. For example, a conductive layer is deposited on a substrate, and P1 scribing is performed on the conductive layer using laser or mechanical methods to complete the division of the conductive layer. Subsequently, a first transport layer, a semiconductor layer, and a second transport layer are deposited, where the semiconductor layer may be a perovskite layer; then, P2 scribing is performed using laser or mechanical methods to create channels for sub-cell series connection. Finally, a top electrode film layer is deposited, and P3 scribing is performed using laser or mechanical methods to separate adjacent sub-cells.

Due to structural design flaws in conventional solar cell modules, P1 and P2 scribing operations are required before achieving sub-cell series connection. Additionally, during P2 scribing, if the scribing energy is too low, it may fail to cut through the two transport layers and the semiconductor layer, leaving residues that prevent the electrode layer from directly contacting the conductive layer. For example, if the scribing energy is too low, perovskite layer residues may remain, hindering sufficient contact between the electrode and the conductive layer, affecting device performance. Conversely, if the scribing energy is too high, it may damage the conductive layer, also leading to increased series resistance between sub-cells, reducing module performance.

In response to the complex preparation process of conventional solar cell modules and the issue of increased series resistance between sub-cells, this application provides a solar cell module. In two adjacent sub-cells, a conductor is connected to the conductive layer of one sub-cell, with at least a portion of the conductor protruding beyond at least one end of the conductive layer along the second direction. That is, at least part of the conductor is located outside the sub-cell, allowing the electrode layer of the other sub-cell to connect with the protruding portion of the conductor outside the sub-cell, thereby achieving series connection between the two sub-cells outside the sub-cells. This eliminates the need for the conventional two scribing operations before electrode layer deposition to achieve series connection, requiring only a cutting operation between sub-cells. Such a design, by providing a conductor protruding at least one end of the conductive layer along the second direction, eliminates the two scribing operations before sub-cell series connection, facilitating a single-cut preparation method, simplifying the preparation process, and improving preparation efficiency. Additionally, eliminating the two scribing operations before series connection reduces cutting damage to the conductive layer, effectively lowering the chance of increased series resistance between sub-cells, thereby enhancing module performance.

Embodiments of this application provide an electrical device using a battery as a power source, which may include, but is not limited to, tablets, laptops, electric toys, power tools, electric bicycles, electric vehicles, ships, spacecraft, space stations, and the like. Electric toys may include fixed or mobile electric toys, such as gaming consoles, electric car toys, electric ship toys, and electric airplane toys.

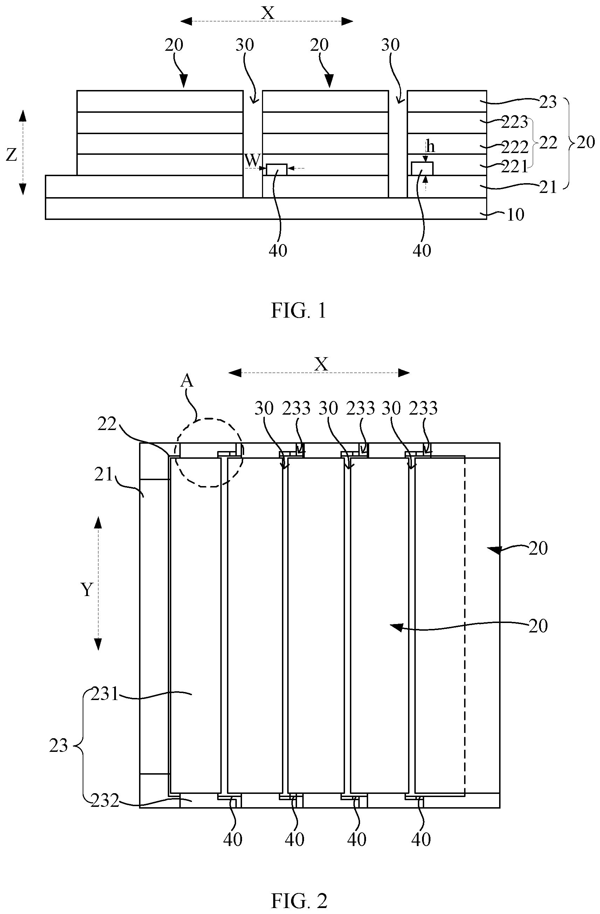

According to some embodiments of this application, referring to FIG. 1 and FIG. 2, this application provides a solar cell module 100, where the solar cell module 100 includes at least two sub-cells 20 and a conductor 40. The sub-cells 20 are distributed at intervals along a first direction X, each sub-cell 20 including a conductive layer 21, a functional layer group 22, and an electrode layer 23 stacked together. In two adjacent sub-cells 20, the conductor 40 is connected to the conductive layer 21 of one sub-cell 20 and at least a portion of the conductor 40 protrudes beyond at least one end of the current conductive layer 21 along a second direction Y. The portion of the conductor 40 protruding beyond the conductive layer 21 is connected to the electrode layer 23 of the other sub-cell 20, the first direction X intersects the second direction Y, and a plane formed by the two intersects a thickness direction Z of the solar cell module 100.

The conductive layer 21 may be a transparent conductive oxide film with an average transmittance of about 80% or higher in the visible light range (wavelength 380 nm (nanometer) to 760 nm, corresponding to energy of 3.26 eV (electron volt) to 1.63 eV) and high conductivity, with a resistivity lower than 1×10⁻³ Ω·cm (ohm-centimeter). Its material may be selected from various options, but is not limited to, indium-doped tin oxide (indium doped tin oxide, ITO), fluorine-doped tin oxide (fluorine doped tin oxide, FTO), aluminum-doped zinc oxide (aluminum doped zinc oxide, AZO), lanthanide-doped indium oxide, antimony-doped tin oxide, boron-doped zinc oxide (BZO), indium zinc oxide (IZO), gallium zinc oxide (GZO), or indium tungsten oxide (IWO).

The functional layer group 22 refers to the core structure in the solar cell module 100, which is a component that converts absorbed light energy into electrical energy. Taking a perovskite cell module as an example, the functional layer group 22 may include a first transport layer 221, a perovskite layer 222, and a second transport layer 223. The first transport layer 221 and the second transport layer 223 are layered structures stacked on two sides of the perovskite layer, primarily responsible for transporting electrons or holes. The first transport layer 221 may be an electron transport layer, and the second transport layer 223 may be a hole transport layer, in which case the solar cell module 100 is an nip-type (normal structure); alternatively, the first transport layer 221 may be a hole transport layer, and the second transport layer 223 may be an electron transport layer, in which case the solar cell module 100 is a pin-type (inverted structure). In addition to transporting electrons, the electron transport layer can block holes, and its material may include, for example, TiO₂, ZnO, SnO₂, or organic materials (such as PCBM, C60, and the like). The hole transport layer, in addition to transporting holes, can block electrons, and its material may include, but is not limited to, spiro-OMeTAD, PTAA (poly[bis(4-phenyl)(2,4,6-trimethylphenyl)amine]), or nickel oxide.

In one embodiment, at least one of the first transport layer 221, perovskite layer 222, or second transport layer 223 may be modified as needed, or a modification layer, such as a passivation layer, may be added between any two layers.

The electrode layer 23, also referred to as the metal electrode layer 23 or back electrode, may be made of materials including, but not limited to, Ag, Au, Pt, or Cu. The sub-cells 20 are distributed at intervals along the first direction X, such as having a scribe groove 30 between two adjacent sub-cells 20, to divide the overall conductive layer 21 into multiple segments, reducing the resistance of the sub-cells 20 while also separating the electrode layers 23 to prevent direct connection between adjacent electrode layers 23.

For separated sub-cells 20, series connection is required. In conventional series connection methods, scribing is first performed on the conductive layer 21 to divide it into multiple segments along the first direction X; then, the functional layer group 22 is deposited; after deposition, scribing is performed on the functional layer group 22 to expose the underlying conductive layer 21, allowing the electrode layer 23 to contact the conductive layer 21 of the next sub-cell 20 during deposition of the electrode layer 23 to achieve series connection. However, this method is not only complex but also prone to damaging the conductive layer 21, affecting module performance.

To address this, this embodiment provides a conductor 40 at at least one end of the conductive layer 21 along the second direction Y, effectively extending the conductive layer 21 outward, enabling the electrode layer 23 to achieve series connection with the conductive layer 21 outside the sub-cell 20, thus eliminating the need for scribing operations on the conductive layer 21 and functional layer. It should be noted that when the electrode layer 23 is connected to the conductive layer 21 via the conductor 40, the two adjacent electrode layers 23 are disconnected and not directly connected. Additionally, in the same sub-cell 20 with a conductor 40, the conductor 40 and the electrode layer 23 within the same sub-cell 20 must not be directly connected. If they were directly connected, it would cause direct conduction between the conductive layer 21 and the electrode layer 23 within the same sub-cell 20, leading to a short circuit in the module.

The conductor 40 refers to a component with conductive functionality, which may be a structure formed by extending the conductive layer 21 outward or a structure with better conductive performance than the conductive layer 21. For example, its material may include, but is not limited to, Ag, Au, Pt, or Cu. The conductor 40 may protrude beyond one end of the current conductive layer 21 along the second direction Y; alternatively, it may protrude beyond two ends of the current conductive layer 21 along the second direction Y, in which case the electrode layers 23 of adjacent sub-cells may respectively connect to the conductor 40 protruding beyond two ends of the conductive layer 21.

Here, the "current conductive layer 21" should be understood as follows: when the conductor 40 is connected to the conductive layer 21, the conductor 40 protrudes beyond at least one end of the conductive layer 21 to which it is connected. The connection between the conductor 40 and the conductive layer 21 may be a direct connection, such as direct contact, or an indirect connection, such as through a conductive component. Additionally, the first direction X, the second direction Y, and the thickness direction Z intersect pairwise and the three are not in the same plane. Specifically, in some embodiments, the first direction X, the second direction Y, and the thickness direction Z are mutually perpendicular.

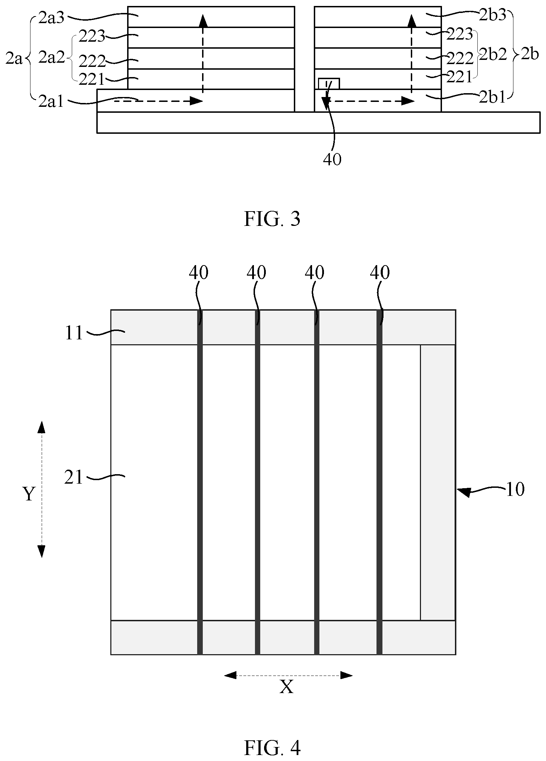

To facilitate understanding of the connection relationship between the sub-cells 20, refer to FIG. 3. The sub-cells 20 may include a first sub-cell 2a and a second sub-cell 2b. Certainly, the number of sub-cells 20 is not limited to the two shown in FIG. 3 and may include others, such as 3, 4, 5, or more. The first sub-cell 2a includes a first conductive layer 2a1, a first functional layer group 2a2, and a first electrode layer 2a3 stacked together, and the second sub-cell 2b includes a second conductive layer 2b1, a second functional layer group 2b2, and a second electrode layer 2b3 stacked together. The conductor 40 is connected to the second conductive layer 2b1 and at least a portion of the conductor 40 protrudes beyond at least one end of the second conductive layer 2b1 along the second direction Y. The protruding portion of the conductor 40 is connected to the first electrode layer 2a3. This allows the first electrode layer 2a3 in the first sub-cell 2a to connect with the second conductive layer 2b1 in the second sub-cell 2b via the conductor 40, achieving series connection between the first sub-cell 2a and the second sub-cell 2b.

In some examples, the first functional layer group 2a2 and the second functional layer group 2b2 each include a first transport layer 221, a perovskite layer 222, and a second transport layer 223 stacked sequentially. Additionally, to ensure a stable circuit and reduce the risk of short circuits, the second electrode layer 2b3 in the second sub-cell 2b must not be electrically connected to the conductor 40.

This design, by providing a conductor 40 protruding at at least one end of the conductive layer 21 along the second direction Y, eliminates the two scribing operations before series connection of the sub-cells 20, facilitating a single-cut preparation method, simplifying the preparation process, and improving preparation efficiency. Additionally, eliminating the two scribing operations before series connection reduces cutting damage to the conductive layer 21, effectively lowering the chance of increased series resistance between sub-cells 20, thereby enhancing module performance.

According to some embodiments of this application, referring to FIG. 4, the conductor 40 is disposed on a side of the conductive layer 21 facing the functional layer group 22 and extends beyond at least one end of the conductive layer 21 along the second direction Y.

The conductor 40 is disposed on one side of the conductive layer 21, with at least one end extending beyond the conductive layer 21 along the second direction Y, indicating that at least a portion of the conductor 40 can extend along the second direction Y on the conductive layer 21. This allows current to be rapidly conducted along the second direction Y through the conductor 40 and then transmitted to the conductive layer 21. Specifically, in some embodiments, the conductor 40 extends along the second direction Y, with two ends of the conductor 40 protruding beyond the conductive layer 21, such that the conductor 40 spans the conductive layer 21 along the second direction Y, facilitating easy current conduction through the conductor 40 along the second direction Y, reducing resistance.

In this design, the conductor 40 is placed on one side of the conductive layer 21, facilitating rapid current conduction along the second direction Y on the conductive layer 21 through the conductor 40, which helps reduce resistance during current conduction and improves module performance.

According to some embodiments of this application, referring to FIG. 4, two ends of the conductor 40 respectively protrude beyond the two ends of the conductive layer 21 along the second direction Y, with at least one of the two ends of the conductor 40 connected to the electrode layer 23 of an adjacent sub-cell 20.

The distribution of the conductor 40 on the conductive layer 21 may vary, for example: the extension direction of the conductor 40 on the conductive layer 21 aligns with the second direction Y; or the extension direction of the conductor 40 intersects the second direction Y; or the conductor 40 extends non-linearly on the conductive layer 21.

Two ends of the conductor 40 respectively protrude beyond two ends of the conductive layer 21 along the second direction Y, and one of the protruding ends may not connect to the electrode layer 23 of another sub-cell; alternatively, the two ends may both connect to the electrode layer 23 of another sub-cell.

Specifically, in some examples, at least one of the two ends of the conductor 40 connects to the electrode layer 23 of the previous sub-cell 20 along the current direction, where the current direction refers to the direction formed when current flows sequentially through each sub-cell 20 during operation of the solar cell module 100, such as under illumination. Certainly, reference may also be made to FIG. 3, the current direction is from the first sub-cell 2a to the second sub-cell 2b. In this case, the first electrode layer 2a3 in the first sub-cell 2a connects to at least one end of the conductor 40 in the second sub-cell 2b.

In this design, both two ends of the conductor 40 are configured to protrude beyond the conductive layer 21, facilitating connection between the electrode layer 23 of another sub-cell 20 and the conductive layer 21 through the protruding portion of the conductor 40, achieving series connection between sub-cells 20.

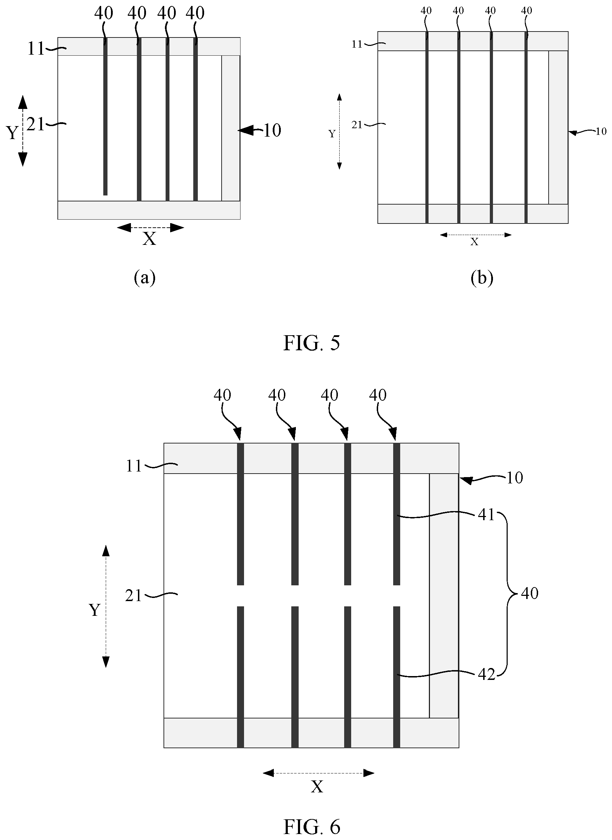

According to some embodiments of this application, referring to FIG. 5, among the two ends of the conductor 40, one protrudes beyond one end of the conductive layer 21 along the second direction Y.

When the conductor 40 is on the conductive layer 21, only one end protrudes beyond the conductive layer 21, that is, one end protrudes beyond one end of the conductive layer 21 along the second direction Y, while the other end does not protrude beyond the conductive layer 21. When there are multiple conductors 40, they may protrude from the same end of the conductive layer 21, as shown in FIG. 5(a); alternatively, some conductors 40 may protrude from one end of the conductive layer 21, while other conductors 40 protrude from the other end, as shown in FIG. 5(b).

This design allows the electrode layer 23 and the conductive layer 21 to connect through one end of the conductor 40.

According to some embodiments of this application, referring to FIG. 6, the conductor 40 includes a first component 41 and a second component 42, the first component 41 and the second component 42 being discontinuously distributed. The first component 41 and the second component 42 respectively protrude beyond the two opposite ends of the conductive layer 21 along the second direction Y and both connect to the electrode layer 23 of an adjacent sub-cell 20.

It can be seen that the conductor 40 on the conductive layer 21 includes two or more segments, namely the first component 41 and the second component 42. The first component 41 and the second component 42 may each connect to the electrode layer 23 of the previous sub-cell 20, allowing current from the previous sub-cell 20 to be transmitted to the conductive layer 21 of the current sub-cell 20 through the first component 41 and the second component 42, achieving series connection.

Additionally, it should be noted that the first component 41 and the second component 42 each connecting to the electrode layer 23 of an adjacent sub-cell 20 can be understood as: the first component 41 and the second component 42 respectively connect to the electrode layer 23 of the previous sub-cell 20 along the current direction. Certainly, in some examples, it can also be understood as: the sub-cells 20 include a first sub-cell 2a and a second sub-cell 2b, as shown in FIG. 2. The first component 41 and the second component 42 respectively connect to the first electrode layer 2a3 in the first sub-cell 2a.

This design facilitates series connection between two adjacent sub-cells 20 through the disconnected first component 41 and second component 42.

According to some embodiments of this application, referring to FIG. 1, a scribe groove 30 is provided between two adjacent sub-cells 20, and the conductor 40 is located on at least one side of the scribe groove 30 along the first direction X and is disposed on the conductive layer 21.

The scribe groove 30 refers to a structure that separates two sub-cells 20. During preparation, cutting may be performed along the thickness direction Z on the electrode layer 23, dividing the electrode layer 23, functional layer group 22, and conductive layer 21 into multiple segments along the first direction X.

Although the scribe groove 30 can form multiple sub-cells 20, the space it occupies creates a dead zone in the solar cell module 100, where the zone cannot receive photons. Therefore, the dimension of the scribe groove 30 along the first direction X should be minimized, for example, the dimension D of the scribe groove 30 along the first direction X may be, but is not limited to, 30 µm to 100 µm. Certainly, in other embodiments, the dimension D of the scribe groove 30 along the first direction X may also be 40 µm to 50 µm.

The distribution position of the conductor 40 on the conductive layer 21 may vary, for example: the conductor 40 may be adjacent to one side of the scribe groove 30 along the first direction X, facilitating connection between the electrode layer 23 of an adjacent sub-cell 20 and the conductor 40. The conductor 40 may be located on either side of the scribe groove 30 along the first direction X. For example, referring to FIG. 1, the conductor 40 may be located on the left side of the scribe groove 30 or on the right side of the scribe groove 30 in FIG. 1. Specifically, in some embodiments, the conductor 40 is disposed on a side of the conductive layer 21 facing the functional layer group 22 and is located on one side of the scribe groove 30 along the first direction X. The conductor 40 extends along the second direction Y and protrudes beyond at least one end of the conductive layer 21 along the second direction Y.

In this design, the conductor 40 is placed on one side of the scribe groove 30, facilitating connection between the electrode layer 23 and the conductor 40 to achieve series connection between sub-cells 20.

According to some embodiments of this application, the solar cell module includes multiple scribe grooves 30 and multiple conductors 40, with at least one conductor 40 located between two adjacent scribe grooves 30.

The presence of multiple scribe grooves 30 indicates that the number of sub-cells 20 along the first direction X is at least three. In this case, the conductors 40 are arranged corresponding to the scribe grooves 30, such that the sub-cell 20 on one side of a scribe groove 30 has at least one conductor 40. Since sub-cells 20 need to be connected in series sequentially, the first sub-cell 20 along the current direction may or may not have a conductor 40. For example, referring to FIG. 1, the first sub-cell 20 along the current direction does not have a conductor 40, while the remaining sub-cells 20 along the current direction each have at least one conductor 40.

When each conductor 40 is located on one side of its corresponding scribe groove 30, the electrode layer 23 on one side of the scribe groove 30 connects to the conductor 40 on the other side of the scribe groove 30 to achieve sequential series connection between sub-cells 20. Specifically, in some embodiments, all of the conductors 40 may be located on the same side of their respective corresponding scribe grooves 30.

Here, "respective corresponding scribe groove 30" can be understood as: the scribe groove 30 closest to the conductor 40 is the scribe groove 30 corresponding to that conductor 40. The term "same side" means that each scribe groove 30 has two sides along the first direction X, and each conductor 40 is located on the same side of its corresponding scribe groove 30. For clarity, referring to FIG. 1, the scribe groove 30 has a left side and a right side along the first direction X, and in FIG. 1, each conductor 40 is located on the right side of its corresponding scribe groove 30.

Additionally, besides placing conductors 40 between scribe grooves 30, a conductor 40 should also be placed on one side of the last scribe groove 30 along the current direction.

In this design, the conductor 40 is placed between two adjacent scribe grooves 30, facilitating sequential connection between each electrode layer 23 and conductor 40 to form a series connection.

According to some embodiments of this application, a dimension of the conductor 40 along the first direction X is smaller than a dimension of the conductive layer 21 along the first direction X.

The conductor 40 on the conductive layer 21 can increase the current conduction area between the two but occupies the effective region of the conductive layer 21, preventing that area from receiving or conducting photons, creating a dead zone on the conductive layer 21. Therefore, the dimension of the conductor 40 along the first direction X should be controlled to be smaller than the dimension of the conductive layer 21 along the first direction X. The dimension of the conductor 40 along the first direction X is significantly smaller than that of the conductive layer 21 along the first direction X.

This design, by controlling the dimensional relationship between the conductor 40 and the conductive layer 21, reduces the dead zone range on the conductive layer 21, thereby improving module performance.

According to some embodiments of this application, referring to FIG. 1, the dimension of the conductor 40 along the first direction X is denoted as W, where 30 µm ≤ W ≤ 200 µm.

The dimension of the conductor 40 along the first direction X affects its conductive performance and the dead zone range on the conductive layer 21. For example, if the dimension of the conductor 40 along the first direction X is too small, it forms a slender structure, reducing the current-carrying cross-sectional area and increasing resistance; if the dimension is too large, it increases the dead zone range on the conductive layer 21, reducing module performance.

Therefore, the dimension W may range from 30 µm to 200 µm, for example, the dimension W may be, but is not limited to, 30 µm, 40 µm, 50 µm, 80 µm, 100 µm, 150 µm, or 200 µm.

This design allowing the controlling of the dimension of the conductor 40 along the first direction X within 30 µm to 200 µm, satisfying rapid current flow while controlling the dead zone range on the conductive layer 21, thus enhancing the performance of the solar cell module 100.

According to some embodiments of this application, the dimension W further satisfies a condition: 80 µm ≤ W ≤ 100 µm.

The dimension W may further range from 80 µm to 100 µm, for example, the dimension W may be, but is not limited to, 80 µm, 82 µm, 84 µm, 86 µm, 88 µm, 90 µm, 92 µm, 94 µm, 96 µm, 98 µm, or 100 µm.

This design further allows controlling of the dimension of the conductor 40 along the first direction X within 80 µm to 100 µm, enabling the design of the conductor 40 to effectively balance its own conductive performance and the effective region on the conductive layer 21.

According to some embodiments of this application, referring to FIG. 1, a dimension of the conductor 40 along the thickness direction Z is denoted as h, where h > 0 nm.

The dimension of the conductor 40 along the thickness direction Z being greater than 0 indicates the presence of the conductor 40, achieving series connection between two sub-cells 20, replacing the conventional P1 and P2 scribing.

In this design, the conductor 40 is introduced to achieve series connection between two sub-cells 20, replacing the conventional P1 and P2 scribing, simplifying the preparation process, and effectively reducing the likelihood of damage caused by scribing to the solar cell module 100, thereby improving module performance.

According to some embodiments of this application, referring to FIG. 1, the dimension of the conductor 40 along the thickness direction Z is denoted as h, where h ≥ 40 nm.

It can be seen that the thickness of the conductor 40 can be controlled to be 40 nm or more, ensuring that the conductivity of the conductor 40 reaches a certain level, improving the conductive performance of the module.

This design allows the controlling of the thickness of the conductor 40 to be 40 nm or more, ensuring good conductive performance of the conductor 40.

According to some embodiments of this application, referring to FIG. 1, the dimension h further satisfies a condition: 40 nm ≤ h ≤ 300 nm.

The dimension of the conductor 40 along the thickness direction Z affects its conductive performance. For example, if the dimension of the conductor 40 along the thickness direction Z is too small, the current-carrying cross-sectional area decreases, increasing resistance. However, the dimension should not be too large, as it may affect the fit gap between the conductive layer 21 and the functional layer group 22.

Therefore, the dimension h may range from 40 nm to 300 nm, for example, the dimension h may be, but is not limited to, 40 nm, 50 nm, 80 nm, 100 nm, 110 nm, 120 nm, 140 nm, 150 nm, 200 nm, or 300 nm.

This design allows the controlling of the dimension of the conductor 40 along the thickness direction Z within 40 nm to 300 nm, ensuring good current-carrying capacity of the solar cell module 100 while maintaining structural stability of the solar cell module 100.

According to some embodiments of this application, the dimension h further satisfies a condition: 50 nm ≤ h ≤ 150 nm.

The dimension h may further range from 50 nm to 150 nm, for example, the dimension h may be, but is not limited to, 50 nm, 60 nm, 80 nm, 84 nm, 88 nm, 90 nm, 95 nm, 100 nm, 105 nm, 110 nm, 115 nm, 120 nm, or 150 nm.

This design allows further controlling of the dimension of the conductor 40 along the thickness direction Z within 50 nm to 150 nm, further enhancing the current-carrying capacity of the solar cell module 100 while maintaining structural stability, thereby improving module performance.

According to some embodiments of this application, the dimension h further satisfies a condition: 80 nm ≤ h ≤ 150 nm.

The dimension h may further range from 80 nm to 150 nm, for example, the dimension h may be, but is not limited to, 80 nm, 84 nm, 88 nm, 90 nm, 95 nm, 100 nm, 105 nm, 110 nm, 115 nm, 120 nm, or 150 nm.

This design allows further controlling of the dimension of the conductor 40 along the thickness direction Z within 80 nm to 150 nm, further enhancing the current-carrying capacity of the solar cell module 100 while maintaining structural stability, thereby improving module performance.

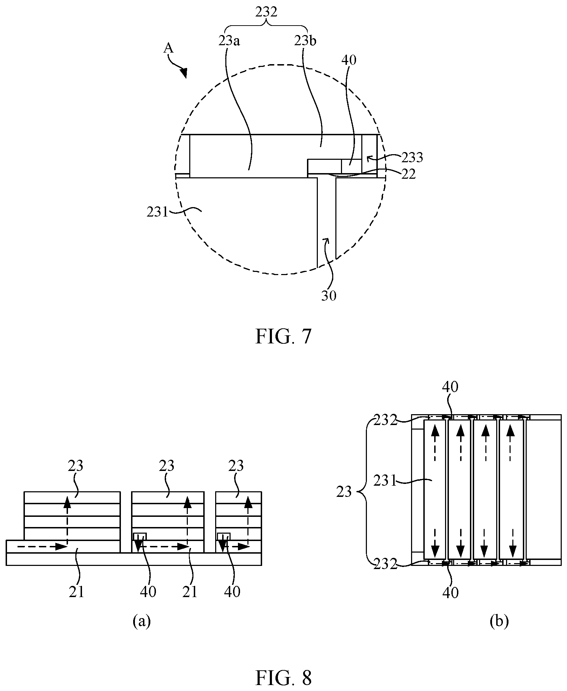

According to some embodiments of this application, referring to FIG. 3 and FIG. 7, each electrode layer 23 includes a main body portion 231 and a connection portion 232 connected to the main body portion 231. The main body portion 231 is disposed on a side of the functional layer group 22 facing away from the conductive layer 21, and the connection portion 232 is located on at least one side of the sub-cell 20 along the second direction Y. In two adjacent sub-cells 20, the connection portion 232 of one sub-cell 20 is connected to the conductor 40 of the other sub-cell 20.

The main body portion 231 refers to the structure covering the side of the functional layer group 22 facing away from the conductive layer 21, and the connection portion 232 is the structure located on at least one side of the sub-cell 20 along the second direction Y. For example, at least a portion of the connection portion 232 may extend along the thickness direction Z, with one end connected to the main body portion 231 and the other end connected to the conductor 40.

During preparation, the main body portion 231 of the electrode layer 23 should not extend beyond the functional layer group 22. For example, referring to FIG. 3 and FIG. 7, two opposite ends of the main body portion 231 along the second direction Y do not extend beyond the functional layer group 22. If they did, it would lead to a connection between the main body portion 231 and the conductor 40, causing a short circuit.

When the connection portion 232 is located on at least one side of the sub-cell 20 along the second direction Y, the connection portion 232 should not contact the conductive layer 21 of the same sub-cell 20 to reduce the risk of a short circuit within the same sub-cell 20. Additionally, in two adjacent sub-cells 20, attention should be paid to the structural design between the electrode layers 23. For example, when the connection portion 232 connects to the conductor 40 of the next sub-cell 20 along the current direction, it should be disconnected from the connection portion 232 in the same sub-cell 20 as the conductor 40 to avoid a short circuit due to connection. For clarity, referring to FIG. 3, the sub-cells 20 may include a first sub-cell 2a and a second sub-cell 2b. The first electrode layer 2a3 of the first sub-cell 2a and the second electrode layer 2b3 of the second sub-cell 2b each include a main body portion 231 and a connection portion 232 connected to the main body portion 231. The conductor 40 is disposed on the second conductive layer 2b1 of the second sub-cell 2b. The connection portion 232 of the first electrode layer 2a3 is connected to the conductor 40, and the second electrode layer 2b3 is not electrically connected to the conductor 40.

In the same electrode layer 23, the number of connection portions 232 may be one or two. When there are two connection portions 232, they are respectively connected to opposite sides of the main body portion 231 and are located on opposite sides of the sub-cell 20 along the second direction Y.

When the connection portion 232 connects to an adjacent conductor 40 to complete the series connection between sub-cells 20, the current flow in the solar cell module 100 can be referred to in FIG. 8 (a) and (b). In FIG. 8 (a), current is conducted from the conductive layer 21 along the thickness direction Z to the main body portion 231 of the electrode layer 23. In FIG. 8 (b), current from the main body portion 231 flows to the connection portions 232 on both sides and is conducted from the connection portion 232 to the conductor 40 of the next sub-cell 20. The current on the conductor 40 is rapidly conducted to the conductive layer 21 of the same sub-cell 20, and then the current on the conductive layer 21 is conducted along the thickness direction Z to the main body portion 231 of the electrode layer 23, repeating this process sequentially.

Additionally, the shape of the connection portion 232 may vary, as long as it can connect to the conductor 40 of an adjacent sub-cell 20. For example, the connection portion 232 may include a first portion 23a and a second portion 23b, with the first portion 23a connected to the main body portion 231, at least a portion of the first portion 23a protruding along the second direction Y away from the main body portion 231, and the second portion 23b connecting between the first portion 23a and the conductor 40. In some examples, when cutting the electrode layer 23, the cutting may be performed at the position between the connected first portion 23a and the conductor 40, that is, the formed scribe groove 30 may be located between the connected first portion 23a and the conductor 40.

In this design, the electrode layer 23 is configured with a main body portion 231 and a connection portion 232, using the main body portion 231 to cover the functional layer group 22 to facilitate current collection to the main body portion 231, while the connection portion 232 enables connection between the electrode layer 23 and the conductor 40, achieving stable series connection between sub-cells 20.

According to some embodiments of this application, referring to FIG. 7, in the same sub-cell 20 with a conductor 40, the electrode layer 23 and the conductor 40 are not short-circuited.

The absence of a short circuit between the electrode layer 23 and the conductor 40 can be understood as: the portion of the electrode layer 23 extending beyond the functional layer group 22 in a direction intersecting the thickness direction Z of the solar cell module 100 (for example, the first direction X or the second direction Y) does not short-circuit with the conductor 40. In this case, the conductor 40 is not directly electrically connected to the electrode layer 23 in the same sub-cell 20, reducing the risk of a short circuit, but is electrically connected to the electrode layer 23 of an adjacent sub-cell 20, such as the conductor 40 connecting to the electrode layer 23 of the previous sub-cell 20 along the current direction. Specifically, in some embodiments, the electrode layer 23 includes a main body portion 231 and a connection portion 232 connected to the main body portion 231. The conductor 40 connects to the connection portion 232 of the previous sub-cell 20 along the current direction but does not connect to the main body portion 231 or connection portion 232 in the same sub-cell 20.

The absence of a short circuit between the electrode layer 23 and the conductor 40 in the same sub-cell 20 ensures that current flows sequentially through the conductor 40, conductive layer 21, functional layer group 22, and electrode layer 23, or sequentially through the electrode layer 23, functional layer group 22, conductive layer 21, and conductor 40. To achieve non-direct conduction between the electrode layer 23 and the conductor 40 in the same sub-cell 20, an insulating material may be placed between the electrode layer 23 and the conductor 40, or a gap may be provided. For example, in the same sub-cell 20 with a conductor 40, the connection portion 232 of the electrode layer 23 and the conductor 40 have a disconnection gap 233 along the first direction X, where the disconnection gap 233 refers to the gap between the connection portion 232 and the conductor 40 in the same sub-cell 20. The gap prevents connection of the two, reducing the risk of a short circuit due to direct conduction between the conductive layer 21 and the electrode layer 23 via the conductor 40. The disconnection gap 233 may be formed in various ways, such as placing a mask plate on the side of the conductor 40 facing away from the corresponding scribe groove 30 during formation of the electrode layer 23, preventing deposition on one side of the conductor 40 during evaporation or sputtering to form the disconnection gap 233; or cutting on one side of the conductor 40 after forming the electrode layer 23 to form the disconnection gap 233.

This design ensures that the conductor 40 and the electrode layer 23 in the same sub-cell 20 are not directly connected, effectively reducing the risk of short circuits and improving module reliability.

According to some embodiments of this application, referring to FIG. 3, two opposite ends of the functional layer group 22 along the second direction Y respectively extend beyond the conductive layer 21 along the second direction Y.

The functional layer group 22 extending beyond the conductive layer 21 indicates that the conductive layer 21 is covered by the functional layer group 22 along the second direction Y, preventing exposure of the conductive layer 21 along the second direction Y and ensuring that the electrode layer 23 does not directly contact the conductive layer 21 during formation.

In some other embodiments, the functional layer group 22 may also extend beyond the conductive layer 21 along the first direction X, effectively covering the effective region of the conductive layer 21.

In this design, the functional layer group 22 is used to cover the conductive layer 21 along the second direction Y, preventing exposure of the conductive layer 21, thereby reducing the risk of short circuits due to direct contact between the electrode layer 23 and the conductive layer 21.

According to some embodiments of this application, referring to FIG. 1, the solar cell module 100 further includes a substrate 10, with the conductive layer 21 disposed on the substrate 10.

The substrate 10, also referred to as a base or substrate, may be made of materials including, but not limited to, glass, tempered glass, quartz, or organic flexible materials; certainly, it may also be transparent conductive glass, stainless steel conductive flexible substrate, or polyethylene glycol terephthalate (polyethylene glycol terephthalate, PET) conductive flexible substrate.

In this design, the substrate 10 is introduced to provide support and protection for the functional layer group 22.

According to some embodiments of this application, referring to FIG. 1, the functional layer group 22 includes a first transport layer 221, a perovskite layer 222, and a second transport layer 223 stacked sequentially. The first transport layer 221 is disposed on the conductive layer 21, and the electrode layer 23 is disposed on the second transport layer 223.

The first transport layer 221 and the second transport layer 223 are layered structures stacked on both sides of the perovskite layer 222, primarily responsible for transporting electrons or holes. The first transport layer 221 may be an electron transport layer, and the second transport layer 223 may be a hole transport layer, in which case the solar cell module 100 is an nip-type (regular structure); alternatively, the first transport layer 221 may be a hole transport layer, and the second transport layer 223 may be an electron transport layer, in which case the solar cell module 100 is a pin-type (inverted structure). In addition to transporting electrons, the electron transport layer can block holes, and its material may include, for example, [6,6]-phenyl-C61-butyric acid methyl ester, C60, cyano-containing polyacetylene, boron-containing polymers, bathocuproine, phenanthroline, hydroxyquinoline aluminum, oxadiazole compounds, benzimidazole compounds, naphthalene tetracarboxylic acid compounds, perylene derivatives, phosphine oxide compounds, phosphorus sulfide compounds, fluorine-containing phthalocyanines, titanium oxide (TiO₂), zinc oxide (ZnO), tin oxide (SnO₂), indium oxide (In₂O₃), gallium oxide (Ga₂O₃), tin sulfide (SnS), indium sulfide (In₂O₃), lithium fluoride (LiF), sodium fluoride (NaF), magnesium fluoride (MgF₂), or zinc sulfide (ZnS). The hole transport layer, in addition to transporting holes, can block electrons, and its material may include thiophene, phthalocyanine, porphyrin, 2,2',7,7'-tetrakis(N,N-di-p-methoxyphenylamine)-9,9'-spirobifluorene, molybdenum oxide (MoO₃), vanadium oxide (V₂O₅), tungsten oxide (WO₃ and/or WO₂), nickel oxide (NiO), copper oxide (CuO), tin oxide (SnO₂), molybdenum sulfide (MoS₂), tungsten sulfide (WS₂), copper sulfide (CuS), tin sulfide (SnS), copper thiocyanate (CuSCN), copper iodide (CuI), fluorine-containing phosphonic acids, carbonyl-containing phosphonic acids, carbon nanotubes, or graphene.

The perovskite layer 222 is a material commonly used in perovskite cells in the art, referring to a structure that absorbs light energy to generate electron/hole pairs. The chemical formula of the perovskite material satisfies ABX₃ or A₂CDX₆, where A is an inorganic cation, an organic ammonium cation, or a mixture of both, and may be at least one of formamidinium ion (FA), methylammonium ion (MA), or Cs; B is an inorganic metal cation, which may be one or more of Pb²⁺, Sn²⁺, Fe²⁺, Mn²⁺, Ni²⁺, Ge²⁺, Co²⁺, or Sb²⁺; C is a noble metal cation, commonly Ag⁺; D is a heavy metal or rare metal cation, which may be at least one of bismuth cation Bi³⁺, antimony cation Sb³⁺, or indium cation In³⁺; X is oxygen or a halogen element, which may be at least one of O, Cl⁻, Br⁻, or I⁻.

In this design, the first transport layer 221, perovskite layer 222, and second transport layer 223 are introduced to form a stable perovskite cell module.

According to some embodiments of this application, a conductivity of the conductor 40 is greater than a conductivity of the conductive layer 21.

Conductivity describes the ease of charge flow in a material, with a higher value indicating better conductive performance of the material. Setting the conductivity of the conductor 40 to be greater than the conductivity of the conductive layer 21 ensures that current transmitted to the conductor 40 can be rapidly conducted.

In some examples, the conductivity of the conductor 40 is greater than or equal to 5×10⁶ S/m. Specifically, in some examples, the material of the conductor 40 may be a single metal, such as silver, copper, gold, aluminum, magnesium, tungsten, molybdenum, zinc, cobalt, nickel, potassium, lithium, iron, platinum, or tin; or it may be a non-metal material, such as carbon fiber, zinc oxide, conductive polymer material, conductive polymeric material, or conductive ceramic material.

In this design, the conductivity of the conductor 40 is rationally set to facilitate rapid current transmission through the conductor 40, thereby improving the conductive performance of the module.

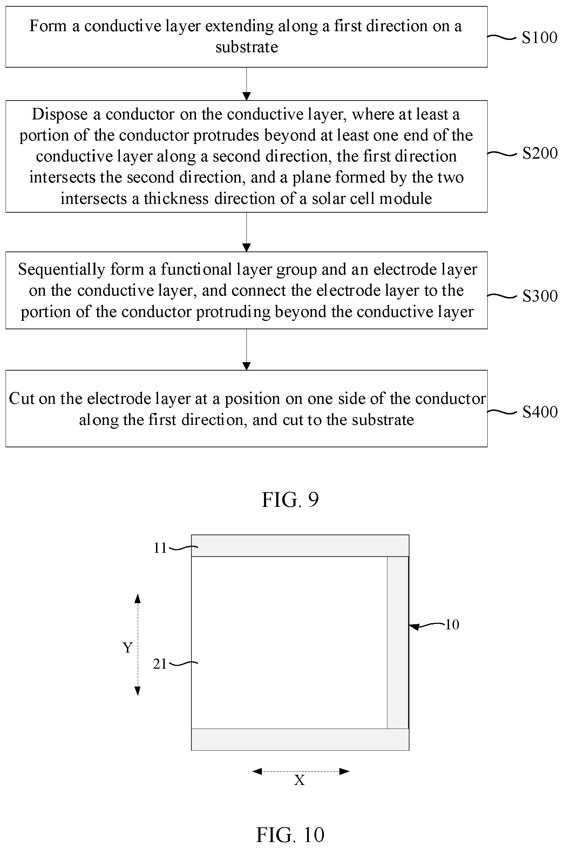

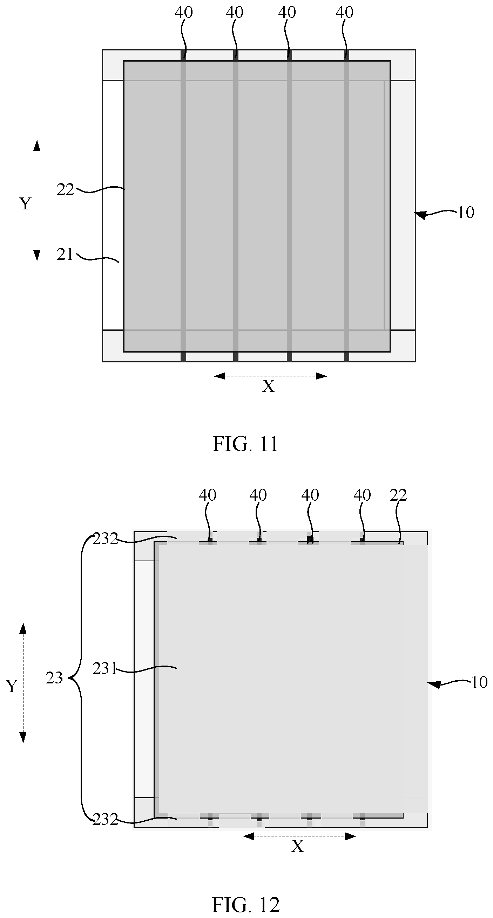

According to some embodiments of this application, referring to FIG. 9, this application provides a method for preparing the above solar cell module, including the following steps:
S100: forming a conductive layer 21 extending along a first direction X on a substrate 10, as shown in FIG. 10;
S200: disposing a conductor 40 on the conductive layer 21, where at least a portion of the conductor 40 protrudes beyond at least one end of the conductive layer 21 along a second direction Y, the first direction X intersecting the second direction Y, and a plane formed by the two intersecting a thickness direction Z of the solar cell module 100, as shown in FIG. 4;
S300: sequentially forming a functional layer group 22 and an electrode layer 23 on the conductive layer 21, and connecting the electrode layer 23 to the portion of the conductor 40 protruding beyond the conductive layer 21, as shown in FIG. 11 and FIG. 12; and
S400: cutting on the electrode layer 23 at a position on one side of the conductor 40 along the first direction X, and cutting to the substrate 10, as shown in FIG. 3.

In step S100, the conductive layer 21 may be formed in various ways, such as, but not limited to, magnetron sputtering, evaporation, printing paste, or spraying.

In step S200, the conductor 40 may be disposed on the conductive layer 21 in various ways, such as placing the conductor 40 along the second direction Y on the conductive layer 21 or connecting the conductor 40 to one end of the conductive layer 21 along the second direction Y, making it protrude beyond the conductive layer 21.

In step S300, the functional layer group 22 may include a first transport layer 221, a perovskite layer 222, and a second transport layer 223. The first transport layer 221 and the second transport layer 223 are layered structures stacked on two sides of the perovskite layer 222, primarily responsible for transporting electrons or holes. The first transport layer 221, perovskite layer 222, and second transport layer 223 may be formed in various ways, such as evaporation, sputtering, or paste coating.

In step S400, cutting is performed on one side of the conductor 40 along the first direction X, effectively dividing the structure into multiple sub-cells 20 while allowing series connection between adjacent sub-cells 20 through the electrode layer 23 and the conductor 40.

The above method for preparing a solar cell module, when forming the conductor 40, ensures that at least a portion of the conductor 40 protrudes beyond at least one end of the conductive layer 21 along the second direction Y. That is, at least part of the conductor 40 is located outside the sub-cell 20, allowing the electrode layer 23 of another sub-cell 20 to connect with the protruding portion of the conductor 40 outside the sub-cell 20, achieving series connection between the two sub-cells 20 outside the sub-cell 20. This eliminates the need for the conventional two scribing operations before electrode layer 23 deposition to achieve series connection, requiring only a cutting operation between sub-cells 20. Such a design, by forming a conductor 40 at at least one end of the conductive layer 21 along the second direction Y, eliminates the two scribing operations before series connection of sub-cells 20, facilitating a single-cut preparation method, simplifying the preparation process, and improving preparation efficiency. Additionally, eliminating the two scribing operations before series connection reduces cutting damage to the conductive layer 21, effectively lowering the chance of increased series resistance between sub-cells 20, thereby enhancing module performance.

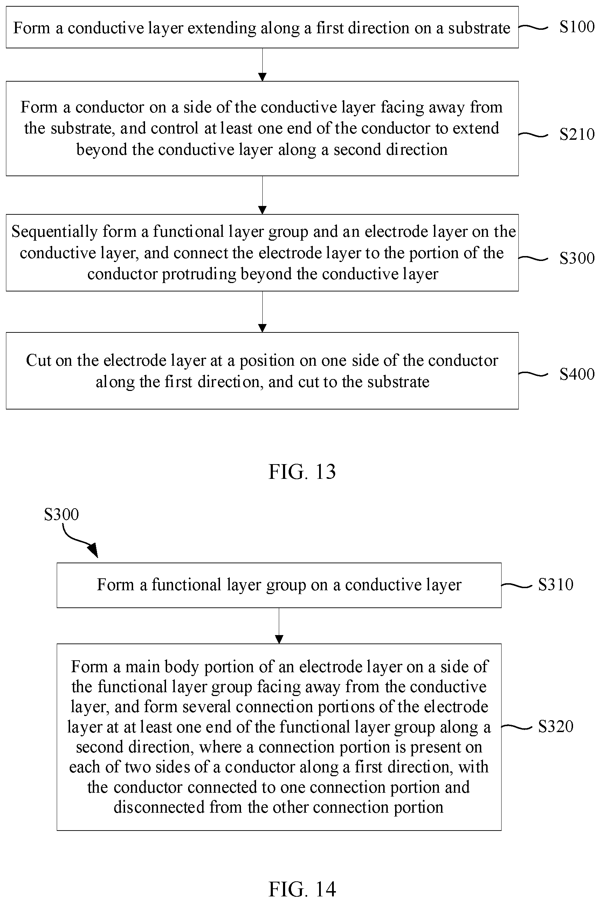

According to some embodiments of this application, referring to FIG. 13, step S200 of disposing a conductor 40 on the conductive layer 21 includes:
S210: forming the conductor 40 on a side of the conductive layer 21 facing away from the substrate 10, and controlling at least one end of the conductor 40 to extend beyond the conductive layer 21 along the second direction Y.

In step S210, directly forming the conductor 40 on one side of the conductive layer 21 increases the conductive area between the conductor 40 and the conductive layer 21. Since at least one end of the conductor 40 extends beyond the conductive layer 21, at least a portion of the conductor 40 extends along the second direction Y on the conductive layer 21. This allows current to be rapidly conducted along the second direction Y through the conductor 40 and then transmitted to the conductive layer 21. Specifically, in some embodiments, the conductor 40 extends along the second direction Y, with two ends protruding beyond the conductive layer 21, such that the conductor 40 spans the conductive layer 21 along the second direction Y, facilitating easy current conduction through the conductor 40 along the second direction Y, reducing resistance.

Additionally, the conductor 40 may be formed on the conductive layer 21 in various ways, such as directly placing the conductor 40 on one side of the conductive layer 21 or forming the conductor 40 on one side of the conductive layer 21 through evaporation, sputtering, or coating.

In this design, the conductor 40 is formed on one side of the conductive layer 21, facilitating rapid current conduction along the second direction Y on the conductive layer 21 through the conductor 40, which helps reduce resistance during current conduction and improves module performance.

According to some embodiments of this application, in the step of forming the conductor 40 on a side of the conductive layer 21 facing away from the substrate 10, the conductor 40 is provided in plurality, and at least part of the conductors are distributed at intervals along the first direction X on the conductive layer 21.

When there are multiple conductors 40, cutting the electrode layer 23 may be performed on the same side of each conductor 40. For example, referring to FIG. 3, during cutting, cuts may be made on the left side of each conductor 40, forming scribe grooves 30 on the left side of each conductor 40. Since cutting is performed on the left side of the conductors 40, the leftmost sub-cell 20 formed does not have a conductor 40. During cutting, it should be noted that along the current direction, the first sub-cell 2a may or may not be provided with a conductor, while the remaining sub-cells must have conductors to ensure series connection between all sub-cells.

In this design, multiple conductors 40 are provided, facilitating stable series connection for sub-cells 20 formed by cutting through the conductors 40.

According to some embodiments of this application, referring to FIG. 14, step S300 of sequentially forming a functional layer group 22 and an electrode layer 23 on the conductive layer 21, and connecting the electrode layer 23 to the portion of the conductor 40 protruding beyond the conductive layer 21, includes:
S310: forming the functional layer group 22 on the conductive layer 21; and
S320: forming a main body portion 231 of the electrode layer 23 on a side of the functional layer group 22 facing away from the conductive layer 21, and forming several connection portions 232 of the electrode layer 23 at at least one end of the functional layer group 22 along the second direction Y, where a connection portion 232 is present on each of two sides of the conductor 40 along the first direction X, with the conductor 40 connected to one connection portion 232 and disconnected from the other connection portion 232.

The main body portion 231 refers to the structure covering the side of the functional layer group 22 facing away from the conductive layer 21, and the connection portion 232 is the structure located on at least one side of the sub-cell 20 along the second direction Y. For example, at least a portion of the connection portion 232 may extend along the thickness direction Z, with one end connected to the main body portion 231 and the other end connected to the conductor 40. It should be noted that during the preparation of the electrode layer 23, the main body portion 231 should not extend beyond the functional layer group 22. For example, referring to FIG. 12, both opposite ends of the main body portion 231 along the second direction Y do not extend beyond the functional layer group 22. If they did, it would lead to a connection between the main body portion 231 and the conductor 40, causing a short circuit.

After performing step S320, when performing step S400, cutting may be performed on the surface of the main body portion 231 of the electrode layer 23 to form several sub-cells 20 on the substrate 10, with the characteristics of the sub-cells 20 referring to the characteristics disclosed in any of the above embodiments, which are not repeated here. When the connection portion 232 is formed on at least one side of the sub-cell 20 along the second direction Y, the connection portion 232 of the previous sub-cell 20 connects to the conductor 40 of the current sub-cell 20, and the connection portion 232 should not contact the conductive layer 21 of the same sub-cell 20 to reduce the risk of a short circuit within the same sub-cell 20. Additionally, in two adjacent sub-cells 20, attention should be paid to the contact issue between the electrode layers 23. For example, when the connection portion 232 connects to the conductor 40 of an adjacent sub-cell, it should be disconnected from the adjacent electrode layer 23 to avoid a short circuit due to connection.

In the same electrode layer 23, the number of connection portions 232 may be one or two. When there are two connection portions 232, they are respectively connected to opposite sides of the main body portion 231 and are located on opposite sides of the sub-cell 20 along the second direction Y.

Additionally, the shape of the connection portion 232 may vary, as long as it can connect to the conductor 40 of an adjacent sub-cell 20. For example, the connection portion 232 may include a first portion 23a and a second portion 23b, with the first portion 23a connected to the main body portion 231, at least a portion of the first portion 23a protruding along the second direction Y away from the main body portion 231, and the second portion 23b connecting between the first portion 23a and the conductor 40. In some examples, when cutting the electrode layer 23, the cutting may be performed at the position between the connected first portion 23a and the conductor 40, that is, the formed scribe groove 30 may be located between the interconnected first portion 23a and the conductor 40.

In this design, the electrode layer 23 is configured with a main body portion 231 and a connection portion 232, using the main body portion 231 to cover the functional layer group 22 to facilitate current collection to the main body portion 231, while the connection portion 232 enables connection between the electrode layer 23 and the conductor 40, achieving stable series connection between sub-cells 20.

According to some embodiments of this application, after the step of cutting on the electrode layer 23 at a position on one side of the conductor 40 along the first direction X, at least two sub-cells 20 are obtained on the substrate 10, and along the current direction of the solar cell module 100, the initial sub-cell 20 does not have a conductor 40.

The initial sub-cell 20 along the current direction can be understood as the first sub-cell 20 along the current direction. Since the first sub-cell 20 does not receive external current input, it does not need a conductor 40. Here, the current direction refers to the direction formed when the solar cell module 100 outputs current during operation, such as under illumination, with the current flowing sequentially from the first sub-cell 20 to the last sub-cell 20.

Certainly, in some other embodiments, each sub-cell 20 may also have at least one conductor 40. For example, along the current direction of the solar cell module 100, the initial sub-cell 20 may also have a conductor 40, which can reduce the resistance of the sub-cell 20, enabling rapid current flow and improving the conductive performance of the module.

In this design, the use of conductors 40 is reduced while achieving series connection between sub-cells 20, thereby lowering costs.

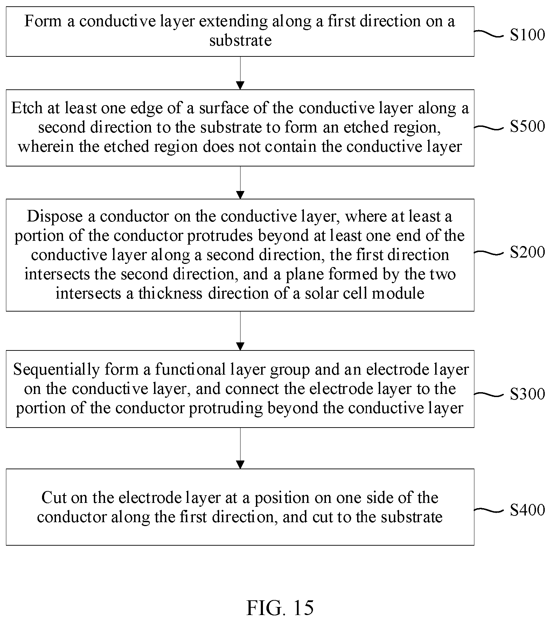

According to some embodiments of this application, referring to FIG. 15, after the step S100 of forming a conductive layer 21 extending along a first direction X on a substrate 10, the method further includes:
S500: etching at least one edge of a surface of the conductive layer 21 along the second direction Y to the substrate 10 to form an etched region 11, where the etched region 11 does not contain the conductive layer 21.

In step S500, etching is performed on the edge of the surface of the conductive layer 21 to remove part of the conductive layer 21, reducing the effective region of the conductive layer 21 and exposing part of the substrate 10. This allows the functional layer group 22 to be formed with a larger area in subsequent steps, enabling the functional layer group 22 to cover the conductive layer 21 along the second direction Y, thus preventing direct contact between the electrode layer 23 and the conductive layer 21, which could lead to a short circuit.

The etched region 11 may be one or multiple. For example, during etching, two edges of the conductive layer 21 along the second direction Y may be etched; alternatively, the edges of the conductive layer 21 along the first direction X may also be etched.

In this design, the effective region of the conductive layer 21 is reduced through etching, allowing the functional layer group 22 to cover the conductive layer 21 along the second direction Y in subsequent synthesis, preventing direct contact between the electrode layer 23 and the conductive layer 21, thereby reducing the risk of short circuits during formation of the electrode layer 23.

According to some embodiments of this application, the step S100 of forming a conductive layer 21 extending along a first direction X on a substrate 10 includes: covering at least one edge of a surface the substrate 10 along the second direction Y with a mask plate; and forming the conductive layer 21 on the substrate 10 with the mask plate.

It can be seen that before forming the conductive layer 21, a mask plate may be placed on at least one edge of the substrate 10 along the second direction Y, preventing the formation of the conductive layer 21 in the covered area. Certainly, in other embodiments, a mask plate may also be placed on at least one edge of the substrate 10 along the first direction X. The mask plate refers to a structure that prevents the formation of the conductive layer 21 on the substrate 10, so the regions covered by the mask plate on the substrate 10 do not contain the conductive layer 21 during formation.

In this design, the effective region of the conductive layer 21 is reduced through the use of a mask plate, allowing the functional layer group 22 to cover the conductive layer 21 along the second direction Y in subsequent synthesis, preventing direct contact between the electrode layer 23 and the conductive layer 21, thereby reducing the risk of short circuits during formation of the electrode layer 23.

According to some embodiments of this application, this application provides a photovoltaic device including the solar cell module 100 according to any one of the above embodiments.

According to some embodiments of this application, this application provides an electrical device including the solar cell module 100 according to any one of the above embodiments.

According to some embodiments of this application, this application provides a power generation device including the solar cell module 100 according to any one of the above embodiments.

According to some embodiments of this application, referring to FIG. 1 to FIG. 15, this application provides a method for preparing a solar cell module. The method involves etching the edges of the conductive layer 21 to form an etched region 11 surrounding the conductive layer 21; then, forming several conductors 40 at intervals along the first direction X on the conductive layer 21, with two ends of the conductors 40 protruding beyond the conductive layer 21 along the second direction Y; subsequently, forming a functional layer group 22 on the conductive layer 21, controlling the perovskite layer 222 in the functional layer group 22 to cover beyond the effective region of the conductive layer 21; forming an electrode layer 23 on the functional layer group 22, connecting the electrode layer 23 to the portion of the conductor 40 protruding beyond the conductive layer 21; and finally, cutting on the same side of each conductor 40 to form multiple sub-cells 20 along the first direction X. In two adjacent sub-cells 20, the electrode layer 23 of one sub-cell 20 connects to the conductor 40 of the other sub-cell 20, and the electrode layer 23 and conductor 40 in the same sub-cell 20 are not short-circuited. Specifically, referring to FIG. 3, along the current direction, the electrode layer 23 of the first sub-cell 20 connects to the conductor 40 of the second sub-cell 20, the electrode layer 23 of the second sub-cell 20 connects to the conductor 40 of the third sub-cell 20, and so on, repeating this configuration sequentially.

To make the objectives, technical solutions, and advantages of this application clearer and more concise, the application is described with the following specific embodiments, but the application is by no means limited to these embodiments. The embodiments described below are only preferred embodiments of the application, which can be used to describe the application but should not be construed as limiting its scope. It should be noted that any modifications, equivalent substitutions, and improvements made within the spirit and principles of this application should be included within the protection scope of the application.

To better illustrate this application, an inverted perovskite cell module is used as an example for further explanation. The following are specific embodiments.

### Comparative Example 1

### Conductive layer 21 preparation

A conductive layer 21 was sputtered on glass and etched to form a 3 cm × 3 cm FTO conductive glass with a thickness of 350 nm; the glass was cleaned twice with acetone and isopropanol, immersed in deionized water for ultrasonic treatment for 10 minutes, dried in a forced-air drying oven, and placed in a glovebox (N₂ atmosphere); after cleaning, P1 scribing was performed on the FTO conductive glass using laser cutting, with 5 P1 scribe lines, each having a width of 50 µm.

### Hole transport layer preparation

The cleaned conductive glass was irradiated under a UV ozone machine for 10 minutes. 50 mg of nickel nitrate hexahydrate was weighed and dissolved in 1 mL of methanol. The solution was stirred with a magnetic stirrer for 2 hours to obtain a light green transparent clear liquid. The liquid was filtered, the supernatant was taken, the supernatant was spin-coated on the conductive glass, and annealing was performed according to the following procedure: held at 80°C for 10 minutes, raised the temperature to 345°C within 30 minutes, held at 345°C for 30 minutes, then cooled to 100°C and removed, obtaining the hole transport layer.

### Perovskite layer 222 preparation

80 mg of formamidinium iodide (FAI), 223 mg of lead iodide (PbI₂), and 15 mg of methylammonium chloride (MACl) were dissolved in 1 mL of solvent, where the solvent was a mixed solvent of N,N-dimethylformamide (DMF) and dimethyl sulfoxide (DMSO) with a volume ratio of 4:1 (DMF:DMSO). The perovskite solution was stirred at room temperature using a magnetic stirrer for 1 hour, filtered, and the supernatant was taken. The hole transport layer was irradiated under UV for 15 min, then 60 µL of the perovskite solution supernatant was applied on the hole transport layer, spin-coated for 30 s using a spin coater, and an annealing process was performed at 150°C for 10 minutes.

### Electron transport layer preparation

A [6,6]-phenyl-C61-butyric acid methyl ester (PCBM, commercially available) solution with a concentration of 20 mg/mL was prepared, using chlorobenzene as the solvent. Using a spin coater, 60 µL of the prepared PCBM solution was spin-coated on the conductive glass with the prepared perovskite layer 222 for 30 seconds. The sample was annealed at 100°C for 10 minutes, then removed from the equipment and cooled to room temperature to obtain the electron transport layer. After obtaining the electron transport layer, P2 scribing was performed using laser cutting, with 5 P2 scribe lines, each having a width of 100 µm.

### Electrode layer 23 preparation

Residual functional layer group 22 was wiped off with cleaning solution, the sample was placed in a mask (Mask) plate for evaporation, and 80 nm of silver was evaporated in a vacuum evaporation device at a rate of 0.1 A/s. After evaporation, P3 scribing was performed to obtain a complete perovskite cell module, with 5 P3 scribe lines, each having a width of 50 µm.

### Comparative Example 2

Essentially the same as Comparative Example 1, except that no P1 or P2 scribing is performed after preparing the conductive layer 21 and the electron transport layer.

### Example 1

Essentially the same as Comparative Example 1, except that after preparing the conductive layer 21, no P1 scribing was performed, and 4 silver grid lines (that is, conductors 40) were formed by evaporation at intervals along the first direction X on the conductive layer 21. Two ends of each silver grid line protruded 1 cm beyond the conductive layer 21, with a width of 100 µm along the first direction X and a thickness of 10 nm along the thickness direction Z. No P2 scribing was performed after preparing the electron transport layer.

Additionally, during electrode layer 23 evaporation, the electrode layer 23 contacted the silver grid lines; scribing was performed at intervals of 6 mm, with a distance of 6 mm between formed scribe grooves 30, which penetrated from the electrode 23 to the conductive layer 21, and the conductive layer, hole transport layer, perovskite layer, and electron transport layer of adjacent sub-cells did not contact each other, with a scribe groove 30 width of 50 µm. Among the 5 sub-cells 20 formed, the leftmost sub-cell 20 along the current direction (that is, the first sub-cell 20) did not have a silver grid line, while the remaining sub-cells 20 each had one silver grid line. The evaporated electrode layer 23 included a main body portion 231 and a connection portion 232, with the main body portion 231 covering the functional layer group 22, and the connection portion 232 connecting to the end of the silver grid line of the next sub-cell 20, while the electrode layer 23 in the same sub-cell 20 did not directly connect to the silver grid line in that sub-cell 20. Along the current direction, the connection portion 232 of the first sub-cell 20 connected to the silver grid line of the second sub-cell 20, the connection portion 232 of the second sub-cell 20 connected to the silver grid line of the third sub-cell 20, and so on, repeating this configuration sequentially. In the remaining 4 sub-cells 20, the distance between the silver grid line and the scribe groove 30 on the left side was 1 mm.

### Example 2

Essentially the same as Example 1, except that the thickness of the silver grid line along the thickness direction Z was 20 nm.

### Example 3

Essentially the same as Example 1, except that the thickness of the silver grid line along the thickness direction Z was 40 nm.

### Example 4

Essentially the same as Example 1, except that the thickness of the silver grid line along the thickness direction Z was 50 nm.

### Example 5

Essentially the same as Example 1, except that the thickness of the silver grid line along the thickness direction Z was 60 nm.

### Example 6

Essentially the same as Example 1, except that the thickness of the silver grid line along the thickness direction Z was 80 nm.

### Example 7

Essentially the same as Example 1, except that the thickness of the silver grid line along the thickness direction Z was 100 nm.

### Example 8

Essentially the same as Example 1, except that the thickness of the silver grid line along the thickness direction Z was 120 nm.

### Example 9

Essentially the same as Example 1, except that the thickness of the silver grid line along the thickness direction Z was 150 nm.

### Example 10

Essentially the same as Example 1, except that the thickness of the silver grid line along the thickness direction Z was 300 nm.

The perovskite cell modules prepared in the above examples and comparative examples were tested, and the obtained cell efficiencies are shown in Table 1.

Testing was conducted using a solar simulator under one sun condition for IV testing, simulating sunlight irradiation on the cell with a solar simulator. Then the I-V characteristics of the cell were measured using a digital source meter, complying with the national standard IEC61215, to obtain parameters such as open-circuit voltage, short-circuit current, fill factor, and efficiency. The efficiency is calculated as: efficiency = open-circuit voltage × short-circuit current × fill factor.

**Table 1**

| No. | Silver grid line thickness (nm) | Cutting structure | Cell efficiency (%) |
|---|---|---|---|
| Comparative Example 1 | 0 | Normal cutting | 17.8 |
| Comparative Example 2 | 0 | Single cutting | 0 |
| Example 1 | 10 | Single cutting | 14.5 |
| Example 2 | 20 | Single cutting | 15.6 |
| Example 3 | 40 | Single cutting | 17.1 |
| Example 4 | 50 | Single cutting | 17.6 |
| Example 5 | 60 | Single cutting | 18.1 |
| Example 6 | 80 | Single cutting | 19.1 |
| Example 7 | 100 | Single cutting | 19.5 |
| Example 8 | 120 | Single cutting | 19.4 |
| Example 9 | 150 | Single cutting | 19.3 |
| Example 10 | 300 | Single cutting | 18.9 |

From Comparative Example 1, Comparative Example 2, and Examples 1 to 10, it can be seen that when silver grid lines are present, this application can obtain a solar cell module through a single cutting process, simplifying the preparation process; additionally, during preparation, it can reduce the likelihood of structural damage caused by scribing to the solar cell module. Furthermore, when the thickness of the silver grid lines ranges from 10 nm to 100 nm, the cell efficiency increases with thickness, resulting in better performance. When the thickness of the silver grid lines is greater than or equal to 40 nm, the performance of the solar cell module in this application is comparable to, or even better than, that obtained by conventional scribing methods. Moreover, when the thickness of the silver grid lines is controlled within 50 nm to 300 nm, the cell efficiency is mostly higher than that of cells with normal cutting, which is beneficial to improving module performance.

To verify the impact of the material and distribution position of the conductor 40 on the performance of the solar cell module, further explanation is provided below with specific embodiments.

### Example 11

Essentially the same as Example 7, except that the material of the conductor 40 was copper.

### Example 12

Essentially the same as Example 7, except that the material of the conductor 40 was gold.

### Example 13

Essentially the same as Example 7, except that the material of the conductor 40 was aluminum.

### Example 14

Essentially the same as Example 7, except that the material of the conductor 40 was zinc.

### Example 15

Essentially the same as Example 7, except that the distance between the silver grid line and the scribe groove 30 on the left side was 2 mm.

### Example 16

Essentially the same as Example 7, except that the distance between the silver grid line and the scribe groove 30 on the left side was 3 mm.

The perovskite cell modules prepared in the above examples and comparative examples were tested (refer to the testing steps above), and the obtained cell efficiencies are shown in Table 2.

**Table 2**

| No. | Conductor thickness (nm) | Conductor material | Left-side distance (mm) | Cutting structure | Cell efficiency (%) |
|---|---|---|---|---|---|
| Example 7 | 100 | Silver | 1 | Single cutting | 19.5 |
| Example 11 | 100 | Copper | 1 | Single cutting | 19.3 |
| Example 12 | 100 | Gold | 1 | Single cutting | 18.9 |
| Example 13 | 100 | Aluminum | 1 | Single cutting | 18.2 |
| Example 14 | 100 | Zinc | 1 | Single cutting | 18.0 |
| Example 15 | 100 | Silver | 2 | Single cutting | 18.9 |
| Example 16 | 100 | Silver | 3 | Single cutting | 18.8 |

From Examples 7 and 11 to 14, it can be seen that when various materials with conductivity greater than that of the conductive layer 21, especially those with conductivity ≥ 5×10⁶ S/m, are used as the conductor 40, the preparation process of the module can be simplified while effectively improving the performance of the solar cell module. Additionally, when non-metal materials such as carbon fiber, conductive polymer materials, conductive polymeric materials, or conductive ceramic materials are used for the conductor 40, similar effects to Example 7 can be achieved.

From Examples 7, 15, and 16, it can be seen that the closer the conductor 40 is to the scribe groove 30 on the conductive layer 21, the higher the cell efficiency, though the change in efficiency is not significant.

The dimension of the conductor 40 along the first direction X is denoted as W, where 30 µm ≤ W ≤ 200 µm. Controlling the dimension of the conductor 40 along the first direction X within 30 µm to 200 µm satisfies rapid current flow while controlling the dead zone range on the conductive layer, enhancing the performance of the solar cell module. Preferably, controlling 80 µm ≤ W ≤ 100 µm further optimizes the design of the conductor to effectively balance its own conductive performance and the effective region on the conductive layer.

To further illustrate this application, a regular perovskite cell module is used as an example for explanation. The following are specific embodiments.

### Comparative Example 3

Essentially the same as Comparative Example 1, except that the distribution positions and preparation processes of the electron transport layer and hole transport layer differed, with the conductive layer, electron transport layer, perovskite layer, hole transport layer, and electrode layer stacked sequentially. The details are as follows:

### Electron transport layer preparation

The cleaned conductive glass was irradiated under a UV ozone machine for 10 minutes. A SnO₂ aqueous solution with a concentration of 15wt% was prepared. 500 µL of the SnO₂ aqueous solution was spin-coated on the FTO glass substrate at 5000 rpm for 60 seconds, annealed at 150°C for 15 minutes, and cooled to room temperature to obtain the electron transport layer.

### Hole transport layer preparation

500 µL of Spiro solution was spin-coated at 2000 rpm for 30 seconds without annealing, with the Spiro solution concentration being 40 mg/mL.

### Comparative Example 4

Essentially the same as Comparative Example 3, except that no P1 or P2 scribing was performed after preparing the conductive layer 21 and the electron transport layer.

### Example 17

Essentially the same as Comparative Example 3, except that after preparing the conductive layer 21, no P1 scribing was performed, and 4 silver grid lines (that is, conductors 40) were formed by evaporation at intervals along the first direction X on the conductive layer 21. Two ends of each silver grid line protruded 1 cm beyond the conductive layer 21, with a width of 100 µm along the first direction X and a thickness of 10 nm along the thickness direction Z. No P2 scribing was performed after preparing the electron transport layer.

Additionally, during electrode layer 23 evaporation, the electrode layer 23 contacted the silver grid lines; P3 scribing was performed at intervals of 6 mm, with a distance of 6 mm between formed scribe grooves 30, the scribe grooves 30 penetrating from the electrode 23 to the conductive layer 21, and the conductive layer, hole transport layer, perovskite layer, and electron transport layer of adjacent sub-cells did not contact each other, with a scribe groove 30 width of 50 µm. Among the 5 sub-cells 20 formed, the leftmost sub-cell 20 along the current direction (that is, the first sub-cell 20) did not have a silver grid line, while the remaining sub-cells 20 each had one silver grid line. The evaporated electrode layer 23 included a main body portion 231 and a connection portion 232, with the main body portion 231 covering the functional layer group 22, and the connection portion 232 connecting to the end of the silver grid line of the next sub-cell 20 along the current direction, while the electrode layer 23 in the same sub-cell 20 did not connect to the silver grid line in that sub-cell 20. Along the current direction, the connection portion 232 of the first sub-cell 20 connected to the silver grid line of the second sub-cell 20, the connection portion 232 of the second sub-cell 20 connected to the silver grid line of the third sub-cell 20, and so on, repeating this configuration sequentially. In the remaining 4 sub-cells 20, the distance between the silver grid line and the scribe groove 30 on the left side was 1 mm.

### Example 18

Essentially the same as Example 17, except that the thickness of the silver grid line along the thickness direction Z was 20 nm.

### Example 19

Essentially the same as Example 17, except that the thickness of the silver grid line along the thickness direction Z was 40 nm.

### Example 20

Essentially the same as Example 17, except that the thickness of the silver grid line along the thickness direction Z was 50 nm.

### Example 21

Essentially the same as Example 17, except that the thickness of the silver grid line along the thickness direction Z was 60 nm.

### Example 22

Essentially the same as Example 17, except that the thickness of the silver grid line along the thickness direction Z was 80 nm.

### Example 23

Essentially the same as Example 17, except that the thickness of the silver grid line along the thickness direction Z was 100 nm.

### Example 24

Essentially the same as Example 17, except that the thickness of the silver grid line along the thickness direction Z was 120 nm.

### Example 25

Essentially the same as Example 17, except that the thickness of the silver grid line along the thickness direction Z was 150 nm.

### Example 26

Essentially the same as Example 17, except that the thickness of the silver grid line along the thickness direction Z was 300 nm.

The perovskite cell modules prepared in the above examples and comparative examples were tested, and the obtained cell efficiencies are shown in Table 3.

**Table 3**

| No. | Silver grid line thickness (nm) | Cutting structure | Cell efficiency (%) |
|---|---|---|---|
| Comparative Example 3 | 0 | Normal cutting | 18.5 |
| Comparative Example 4 | 0 | Single cutting | 0 |
| Example 17 | 10 | Single cutting | 15.1 |
| Example 18 | 20 | Single cutting | 16.2 |
| Example 19 | 40 | Single cutting | 17.8 |
| Example 20 | 50 | Single cutting | 18.3 |
| Example 21 | 60 | Single cutting | 18.8 |
| Example 22 | 80 | Single cutting | 19.8 |
| Example 23 | 100 | Single cutting | 20.3 |
| Example 24 | 120 | Single cutting | 20.2 |
| Example 25 | 150 | Single cutting | 20.1 |
| Example 26 | 300 | Single cutting | 19.6 |

From Comparative Example 3, Comparative Example 4, and Examples 17 to 26, it can be seen that, whether for an inverted structure or a regular structure, when the thickness of the silver grid lines ranges from 10 nm to 100 nm, the cell efficiency increases with thickness, resulting in better performance. Additionally, when the thickness of the silver grid lines is controlled within 50 nm to 300 nm, the cell efficiency is mostly higher than that of cells with normal cutting, which is beneficial to improving module performance.

The technical features of the above embodiments can be arbitrarily combined. To keep the description concise, not all possible combinations of the technical features in the above embodiments are described. However, as long as there is no contradiction in the combination of these technical features, they should be considered within the scope of this specification.

The above embodiments only express several implementation modes of this application, with specific and detailed descriptions, but they should not be construed as limiting the scope of the patent application. It should be noted that for those of ordinary skill in the art, several variations and improvements can be made without departing from the concept of this application, all of which fall within the protection scope of this application. Therefore, the protection scope of this patent application shall be subject to the appended claims.

## Claims

1. A solar cell module, comprising:
at least two sub-cells, distributed at intervals along a first direction, each sub-cell comprising a conductive layer, a functional layer group, and an electrode layer stacked together;
wherein, the solar cell module further comprises a conductor, and in two adjacent sub-cells, the conductor is connected to the conductive layer of one sub-cell and at least a portion of the conductor protrudes beyond at least one end of the current conductive layer along a second direction, the portion of the conductor protruding beyond the conductive layer is connected to the electrode layer of the other sub-cell, the first direction intersects the second direction, and a plane formed by the two intersects a thickness direction of the solar cell module.

2. The solar cell module according to claim 1, wherein the conductor is disposed on a side of the conductive layer facing the functional layer group and extends beyond at least one end of the conductive layer along the second direction.

3. The solar cell module according to claim 2, wherein two ends of the conductor respectively protrude beyond two opposite ends of the conductive layer along the second direction, with at least one of the two ends of the conductor connected to the electrode layer of an adjacent sub-cell.

4. The solar cell module according to claim 2 or 3, wherein the conductor comprises a first component and a second component, the first component and the second component being discontinuously distributed, and the first component and the second component respectively protruding beyond the two opposite ends of the conductive layer along the second direction and both being connected to the electrode layer of an adjacent sub-cell.

5. The solar cell module according to any one of claims 1 to 4, wherein a scribe groove is provided between two adjacent sub-cells, and the conductor is located on at least one side of the scribe groove along the first direction and is disposed on the conductive layer.

6. The solar cell module according to claim 5, wherein the solar cell module comprises multiple scribe grooves and multiple conductors, with at least one conductor located between two adjacent scribe grooves.

7. The solar cell module according to any one of claims 2 to 6, wherein a dimension of the conductor along the first direction is smaller than a dimension of the conductive layer along the first direction.

8. The solar cell module according to claim 7, wherein the dimension of the conductor along the first direction is denoted as W, wherein 30 µm ≤ W ≤ 200 µm.

9. The solar cell module according to claim 8, wherein the dimension W further satisfies a condition: 80 µm ≤ W ≤ 100 µm.

10. The solar cell module according to any one of claims 2 to 9, wherein a dimension of the conductor along the thickness direction is denoted as h, wherein h > 0 nm.

11. The solar cell module according to claim 10, wherein the dimension h further satisfies a condition: h ≥ 40 nm.

12. The solar cell module according to claim 10 or 11, wherein,
the dimension h further satisfies a condition: 40 nm ≤ h ≤ 300 nm.

13. The solar cell module according to any one of claims 10 to 12, wherein the dimension h further satisfies a condition: 50 nm ≤ h ≤ 150 nm.

14. The solar cell module according to any one of claims 10 to 13, wherein the dimension h further satisfies a condition: 80 nm ≤ h ≤ 150 nm.

15. The solar cell module according to any one of claims 1 to 14, wherein each electrode layer comprises a main body portion and a connection portion connected to the main body portion, the main body portion being disposed on a side of the functional layer group facing away from the conductive layer, and the connection portion being located on at least one side of the sub-cell along the second direction; and
in two adjacent sub-cells, the connection portion of one sub-cell is connected to the conductor of the other sub-cell.

16. The solar cell module according to any one of claims 1 to 15, wherein two opposite ends of the functional layer group along the second direction respectively extend beyond the conductive layer along the second direction.

17. The solar cell module according to any one of claims 1 to 16, wherein the solar cell module further comprises a substrate, with the conductive layer disposed on the substrate.

18. The solar cell module according to any one of claims 1 to 17, wherein the functional layer group comprises a first transport layer, a perovskite layer, and a second transport layer stacked sequentially, the first transport layer being disposed on the conductive layer, and the electrode layer being disposed on the second transport layer.

19. The solar cell module according to claim 18, wherein the first transport layer is a hole transport layer, and the second transport layer is an electron transport layer.

20. The solar cell module according to claim 18, wherein the first transport layer is an electron transport layer, and the second transport layer is a hole transport layer.

21. The solar cell module according to any one of claims 1 to 20, wherein a conductivity of the conductor is greater than a conductivity of the conductive layer.

22. The solar cell module according to claim 21, wherein the conductivity of the conductor is greater than or equal to 5×10⁶ S/m.

23. The solar cell module according to claim 21 or 22, wherein the conductor is at least one of silver, copper, gold, aluminum, magnesium, tungsten, molybdenum, zinc, cobalt, nickel, potassium, lithium, iron, platinum, tin, carbon fiber, zinc oxide, conductive polymer material, conductive polymeric material, or conductive ceramic material.

24. The solar cell module according to any one of claims 1 to 23, wherein the conductive layer comprises at least one of indium-doped tin oxide, fluorine-doped tin oxide, aluminum-doped zinc oxide, lanthanide-doped indium oxide, antimony-doped tin oxide, boron-doped zinc oxide, indium zinc oxide, gallium zinc oxide, or indium tungsten oxide.

25. A method for preparing the solar cell module according to any one of claims 1 to 24, comprising the following steps:
forming a conductive layer extending along a first direction on a substrate;
disposing a conductor on the conductive layer, wherein at least a portion of the conductor protrudes beyond at least one end of the conductive layer along a second direction, the first direction intersecting the second direction, and a plane formed by the two intersecting a thickness direction of the solar cell module;
sequentially forming a functional layer group and an electrode layer on the conductive layer, and connecting the electrode layer to the portion of the conductor protruding beyond the conductive layer; and
cutting on the electrode layer at a position on one side of the conductor along the first direction, and cutting to the substrate.

26. The method for preparing the solar cell module according to claim 25, wherein the step of disposing a conductor on the conductive layer comprises:
forming the conductor on a side of the conductive layer facing away from the substrate, and controlling at least one end of the conductor to extend beyond the conductive layer along the second direction.

27. The method for preparing the solar cell module according to claim 26, wherein in the step of forming the conductor on a side of the conductive layer facing away from the substrate, the conductor is provided in plurality, and at least part of the conductors are distributed at intervals along the first direction on the conductive layer.

28. The method for preparing the solar cell module according to any one of claims 25 to 27, wherein the step of sequentially forming a functional layer group and an electrode layer on the conductive layer, and connecting the electrode layer to the portion of the conductor protruding beyond the conductive layer, comprises:
forming the functional layer group on the conductive layer; and
forming a main body portion of the electrode layer on a side of the functional layer group facing away from the conductive layer, and forming several connection portions of the electrode layer at at least one end of the functional layer group along the second direction, wherein a connection portion is present on each of two sides of the conductor along the first direction, with the conductor connected to one connection portion and not connected to the other connection portion.

29. The method for preparing the solar cell module according to any one of claims 25 to 28, wherein after the step of forming a conductive layer extending along a first direction on a substrate, the method further comprises:
etching at least one edge of a surface of the conductive layer along the second direction to the substrate to form an etched region, wherein the etched region does not contain the conductive layer.

30. The method for preparing the solar cell module according to any one of claims 25 to 28, wherein the step of forming a conductive layer extending along a first direction on a substrate comprises:
covering at least one edge of a surface of the substrate along the second direction with a mask plate; and
forming the conductive layer on the substrate with the mask plate.

31. A photovoltaic device, wherein the photovoltaic device comprises the solar cell module according to any one of claims 1 to 24.

32. An electrical device, wherein the electrical device comprises the solar cell module according to any one of claims 1 to 24.

33. A power generation device, wherein the power generation device comprises the solar cell module according to any one of claims 1 to 24.
